# EUROPEAN PATENT APPLICATION

(11) **EP 4 130 563 A1**
(43) Date of publication of application: **08.02.2023**
(21) Application number: 21780589.4
(22) Date of filing: 31.03.2021
(51) Int. Cl.: F21V 8/00, F21Y 115/10, F21Y 115/30, H01L 33/50, G02B 5/20, F21V 7/08, F21V 7/26, H01S 5/022

(54) **OPTICAL CONVERSION DEVICE AND ILLUMINATION SYSTEM**

(30) Priority: 31.03.2020 JP 2020063620
(71) Applicant: Kyocera Corporation, Kyoto-shi Kyoto 612-8501 (JP)
(72) Inventor: NIINO Noritaka, Kyoto-shi, Kyoto 612-8501 (JP); AKASHI Tomoyoshi, Kyoto-shi, Kyoto 612-8501 (JP)
(74) Representative: Viering, Jentschura & Partner mbB Patent- und Rechtsanwälte
(86) International application number: PCT/JP2021/013941
(87) International publication number: WO 2021/201138

(57) **Abstract**

A photoconversion device includes a wavelength converter including a plurality of phosphor areas, a drive, and a controller. The plurality of phosphor areas includes a first phosphor area to emit fluorescence with a first wavelength spectrum in response to excitation light and a second phosphor area to emit fluorescence with a second wavelength spectrum different from the first wavelength spectrum in response to the excitation light. The drive changes an illuminating area to receive the excitation light in the plurality of phosphor areas. The controller drives the drive to change the illuminating area in the plurality of phosphor areas and stop driving the drive to define the illuminating area in the plurality of phosphor areas.

## Description

### TECHNICAL FIELD

The present disclosure relates to a photoconversion device and an illumination system.

### BACKGROUND OF INVENTION

A known device converts monochromatic excitation light emitted by a light-emitting element to light with a different wavelength using a phosphor substance and emits pseudo white light (refer to, for example, Japanese Unexamined Patent Application Publication No. 2011-181739).

### SUMMARY

One or more aspects of the present disclosure are directed to a photoconversion device and an illumination system.

In one aspect, a photoconversion device includes a wavelength converter including a plurality of phosphor areas, a drive, and a controller. The plurality of phosphor areas includes a first phosphor area to emit fluorescence with a first wavelength spectrum in response to excitation light and a second phosphor area to emit fluorescence with a second wavelength spectrum different from the first wavelength spectrum in response to the excitation light. The drive changes an illuminating area to receive the excitation light in the plurality of phosphor areas. The controller drives the drive to change the illuminating area in the plurality of phosphor areas and stop driving the drive to define the illuminating area in the plurality of phosphor areas.

In one aspect, an illumination system includes a light-emitting module, a first optical transmission fiber, a relay, a second optical transmission fiber, and an optical radiation module. The light-emitting module emits excitation light. The first optical transmission fiber transmits the excitation light from the light-emitting module. The relay includes the photoconversion device according to the above aspect. The second optical transmission fiber transmits the fluorescence from the relay. The optical radiation module radiates the fluorescence transmitted by the second optical transmission fiber into an external space.

### BRIEF DESCRIPTION OF THE DRAWINGS

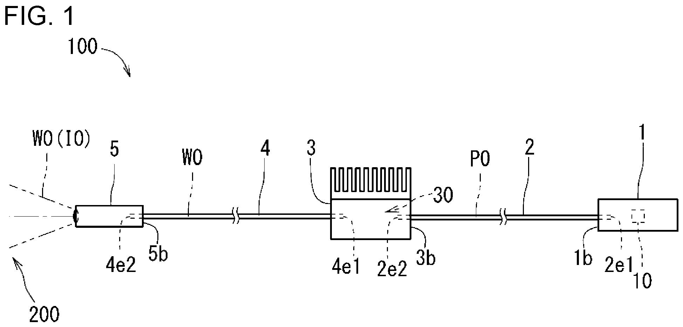

FIG. 1 is a schematic diagram of an example illumination system according to a first embodiment.

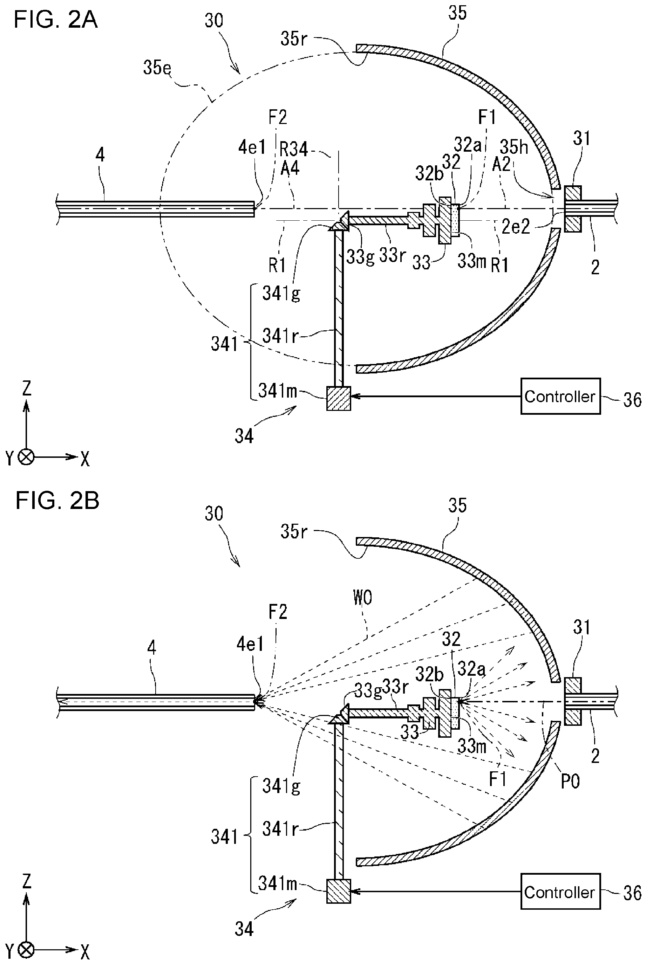

FIG. 2A is a schematic cross-sectional view of a photoconversion device with an example structure according to the first embodiment, and FIG. 2B is a schematic cross-sectional view of the photoconversion device according to the first embodiment describing conversion of excitation light to fluorescence.

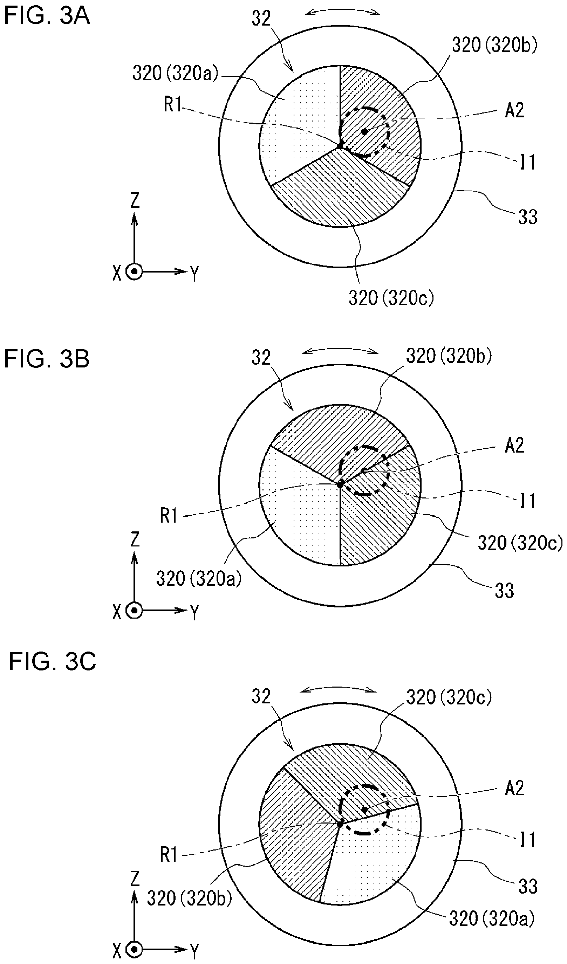

FIGs. 3A to 3C are diagrams of example multiple phosphor areas describing example change of an illuminating area in a wavelength converter.

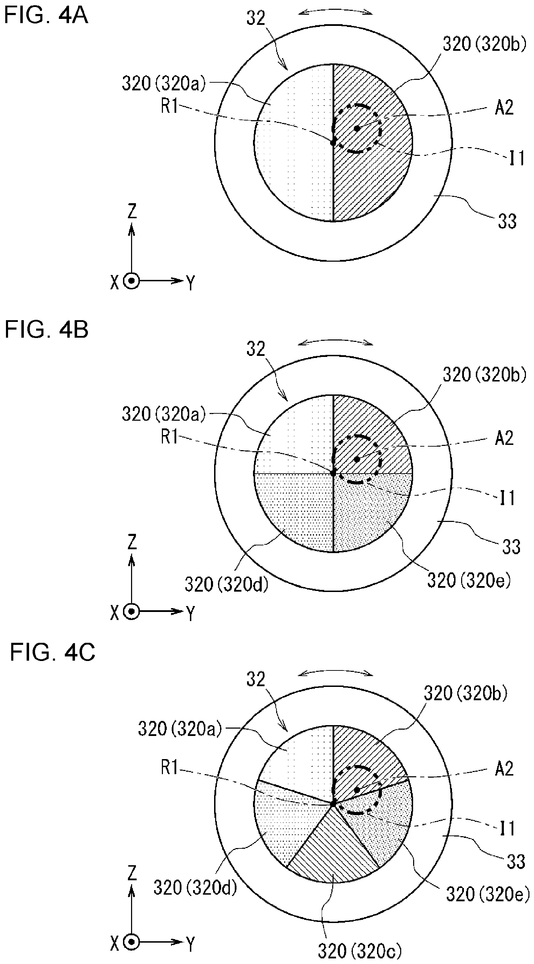

FIGs. 4A to 4C are diagrams of example multiple phosphor areas describing example movement of an illuminating area in the wavelength converter.

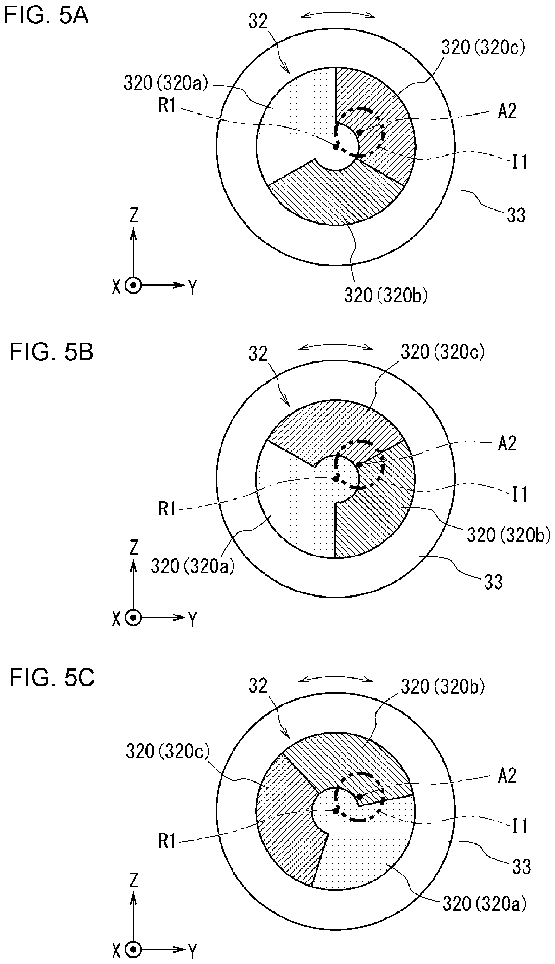

FIGs. 5A to 5C are diagrams of example multiple phosphor areas describing example change of the illuminating area in the wavelength converter.

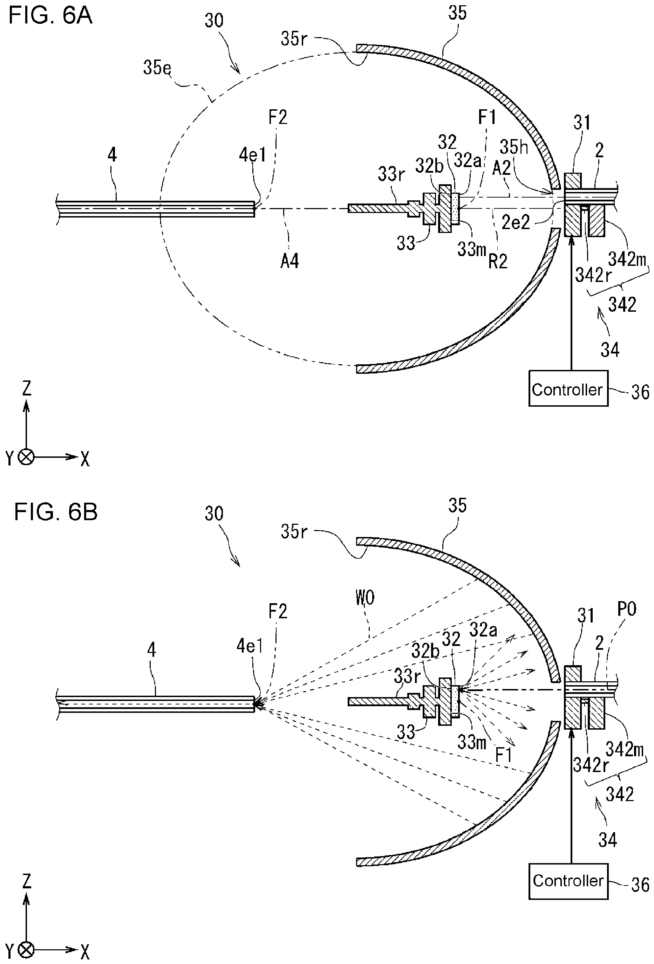

FIG. 6A is a schematic cross-sectional view of a photoconversion device with an example structure according to a second embodiment, and FIG. 6B is a schematic cross-sectional view of the photoconversion device according to the second embodiment describing conversion of excitation light to fluorescence.

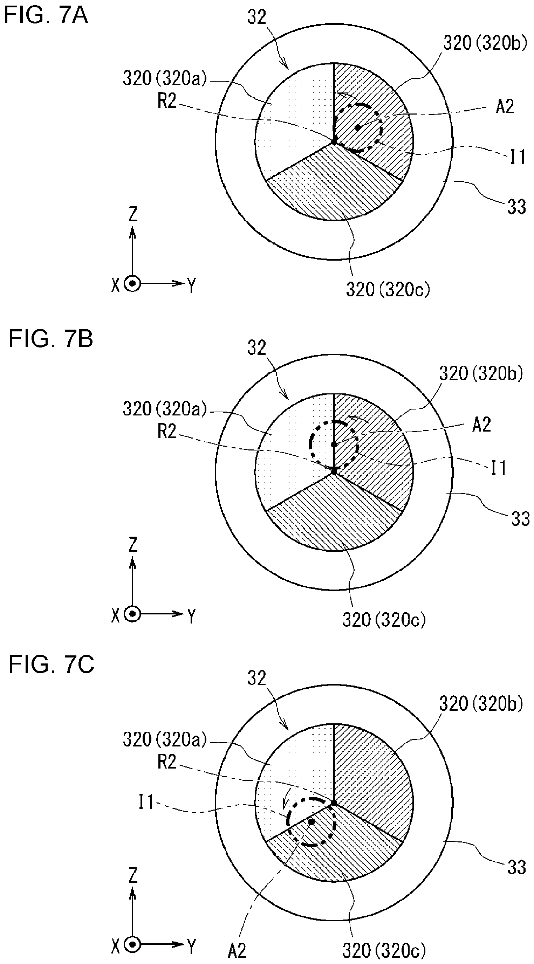

FIGs. 7A to 7C are diagrams of example multiple phosphor areas describing example movement of an illuminating area in a wavelength converter.

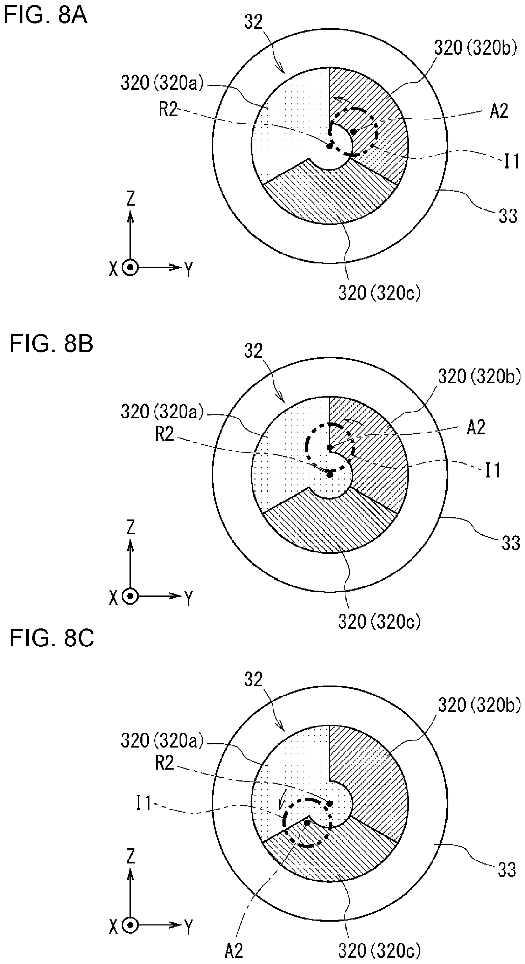

FIGs. 8A to 8C are diagrams of example multiple phosphor areas describing example movement of the illuminating area in the wavelength converter.

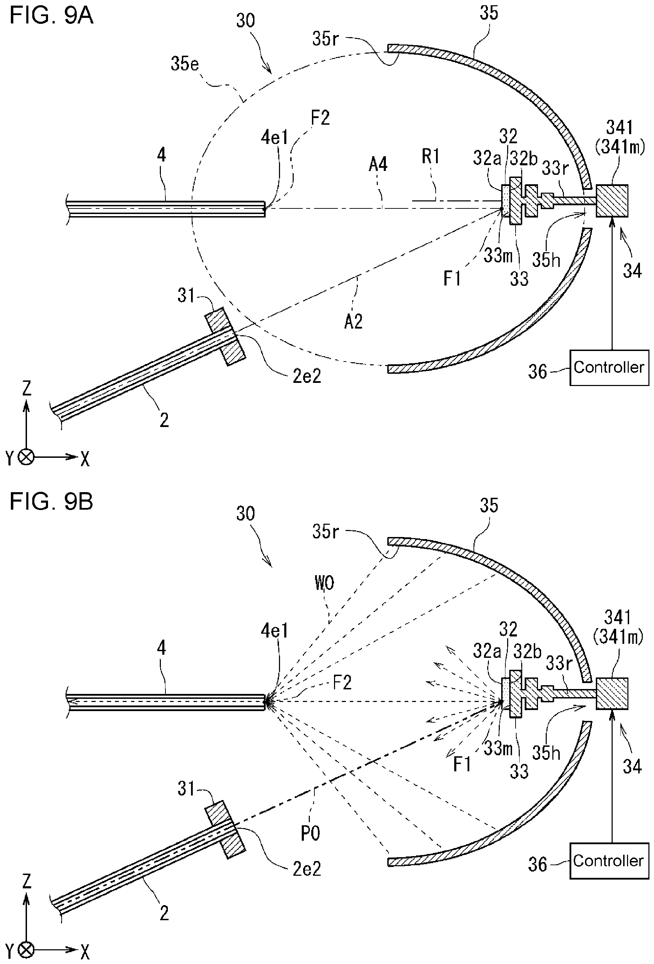

FIG. 9A is a schematic cross-sectional view of a photoconversion device with a first structure according to a third embodiment and FIG. 9B is a schematic cross-sectional view of the photoconversion device with the first structure according to the third embodiment describing conversion of excitation light to fluorescence.

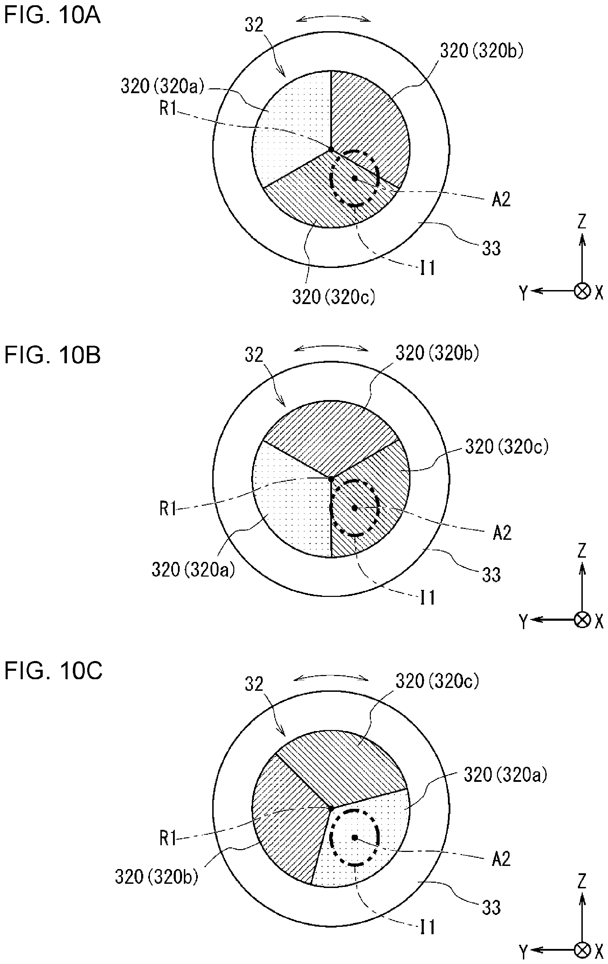

FIGs. 10A to 10C are diagrams of example multiple phosphor areas describing example change of an illuminating area in a wavelength converter.

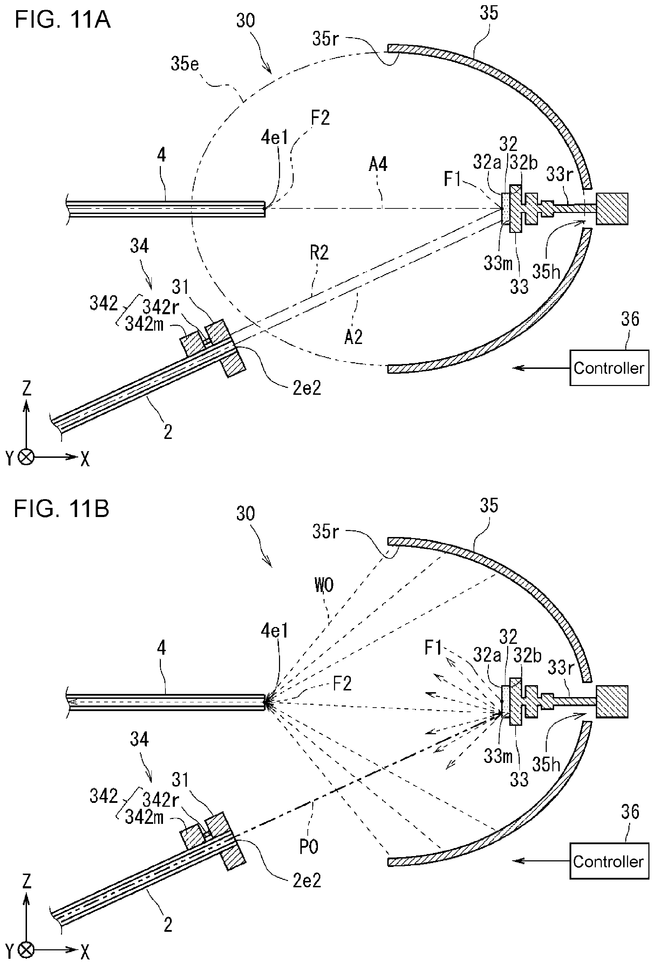

FIG. 11A is a schematic cross-sectional view of a photoconversion device with a second structure according to the third embodiment, and FIG. 11B is a schematic cross-sectional view of the photoconversion device with the second structure according to the third embodiment describing conversion of excitation light to fluorescence.

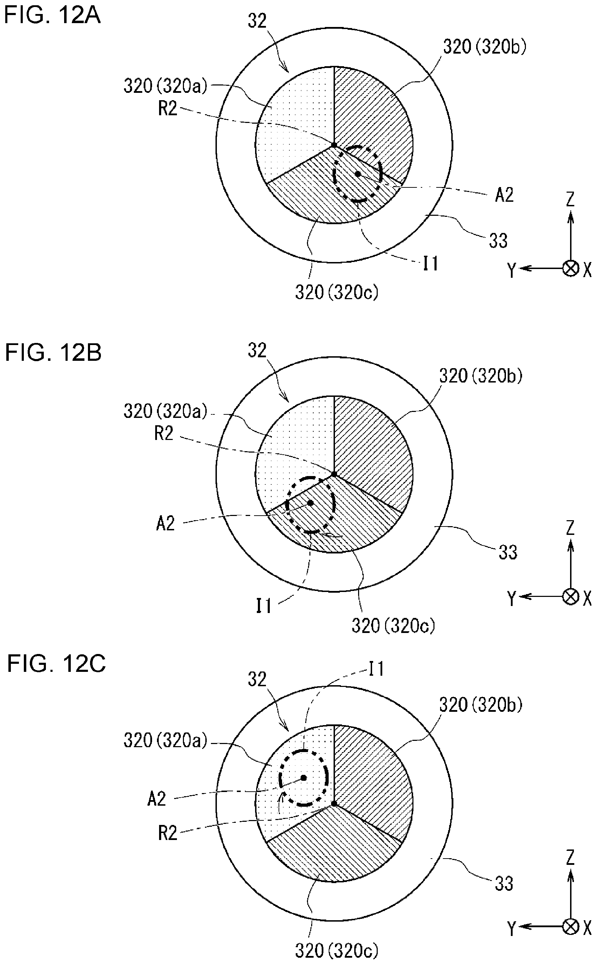

FIGs. 12A to 12C are diagrams of example multiple phosphor areas describing example change of the illuminating area in the wavelength converter.

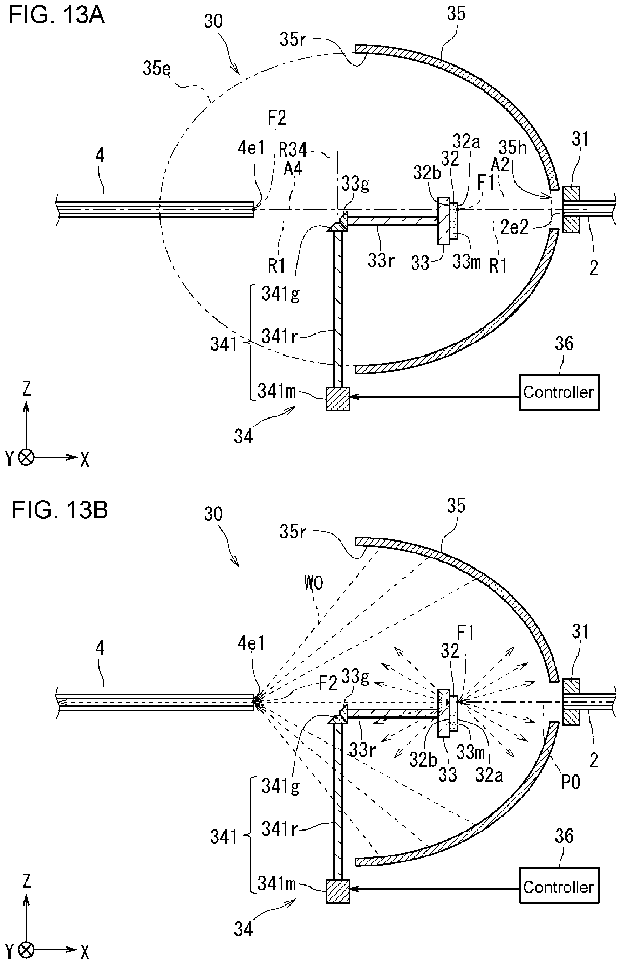

FIG. 13A is a schematic cross-sectional view of a photoconversion device with a first structure according to a fourth embodiment, and FIG. 13B is a schematic cross-sectional view of the photoconversion device with the first structure according to the fourth embodiment describing conversion of excitation light to fluorescence.

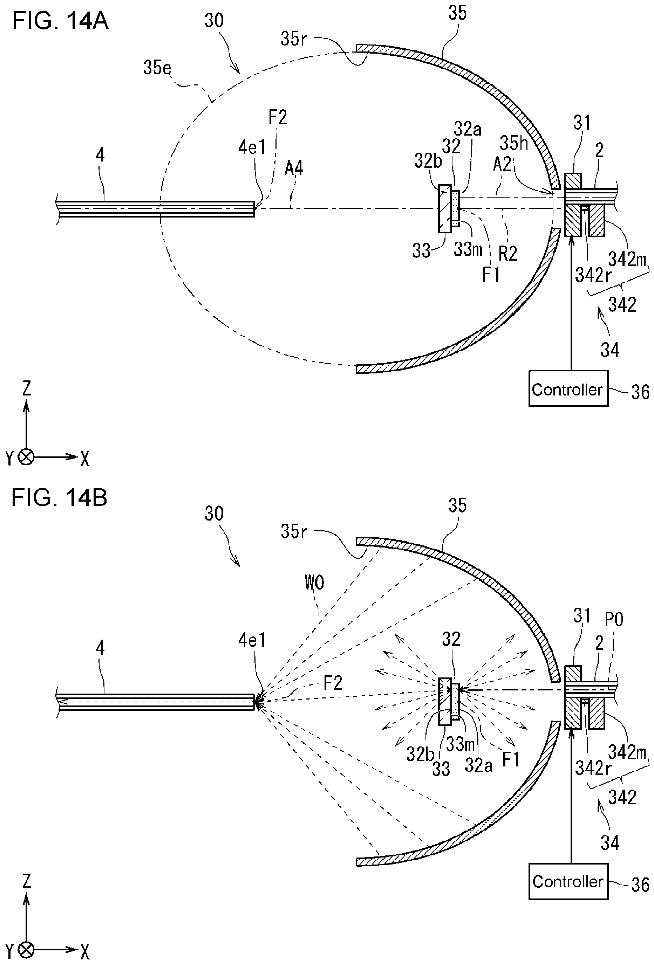

FIG. 14A is a schematic cross-sectional view of a photoconversion device with a second structure according to the fourth embodiment, and FIG. 14B is a schematic cross-sectional view of the photoconversion device with the second structure according to the fourth embodiment describing conversion of excitation light to fluorescence.

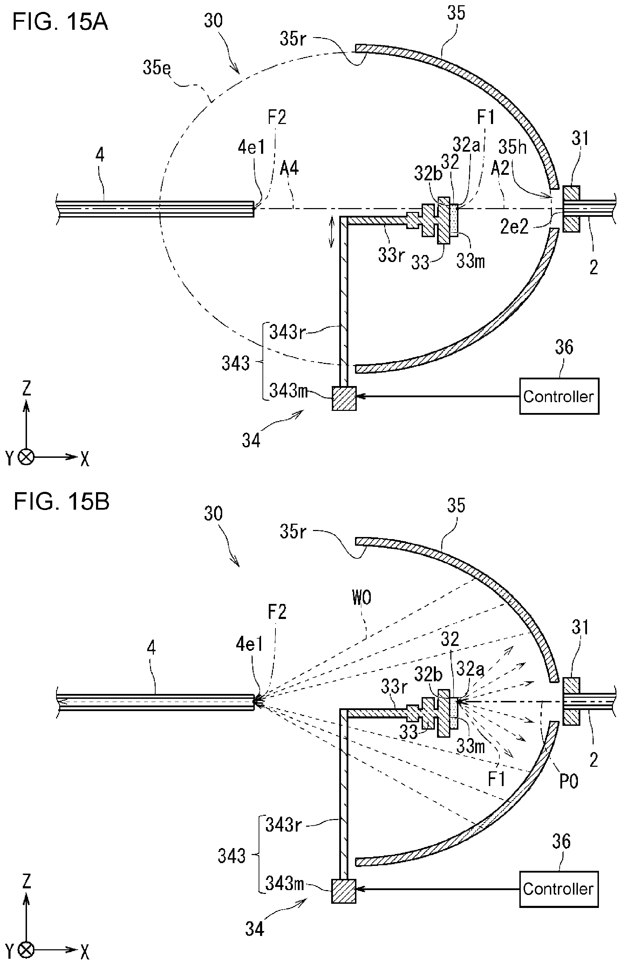

FIG. 15A is a schematic cross-sectional view of a photoconversion device with a first structure according to a fifth embodiment, and FIG. 15B is a schematic cross-sectional view of the photoconversion device with the first structure according to the fifth embodiment describing conversion of excitation light to fluorescence.

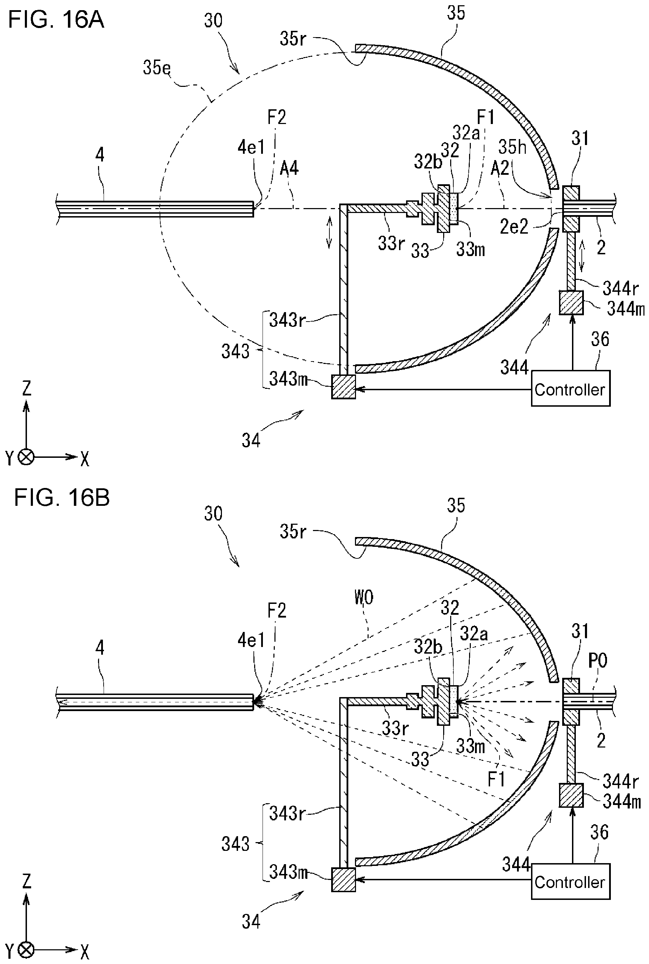

FIG. 16A is a schematic cross-sectional view of a photoconversion device with a second structure according to the fifth embodiment, and FIG. 16B is a schematic cross-sectional view of the photoconversion device with the second structure according to the fifth embodiment describing conversion of excitation light to fluorescence.

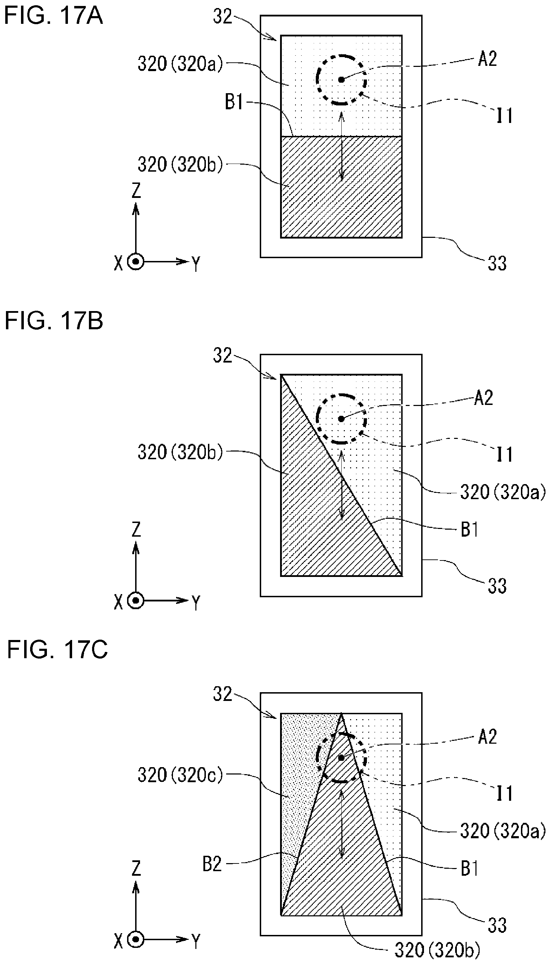

FIGs. 17A to 17C are diagrams of example multiple phosphor areas describing example movement of an illuminating area in a wavelength converter.

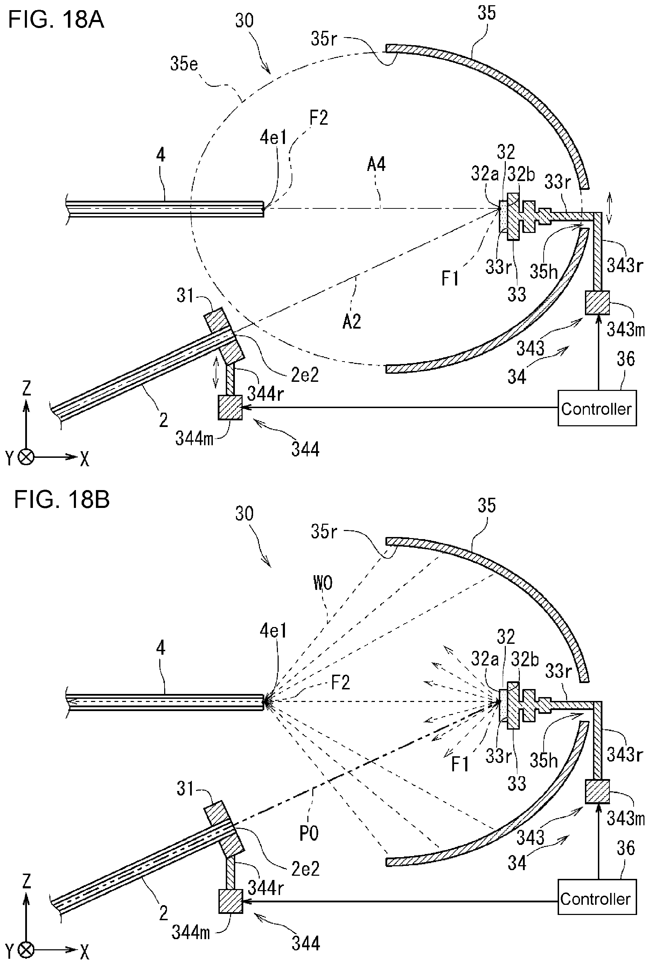

FIG. 18A is a schematic cross-sectional view of a photoconversion device with a third structure according to the fifth embodiment, and FIG. 18B is a schematic cross-sectional view of the photoconversion device with the third structure according to the fifth embodiment describing conversion of excitation light to fluorescence.

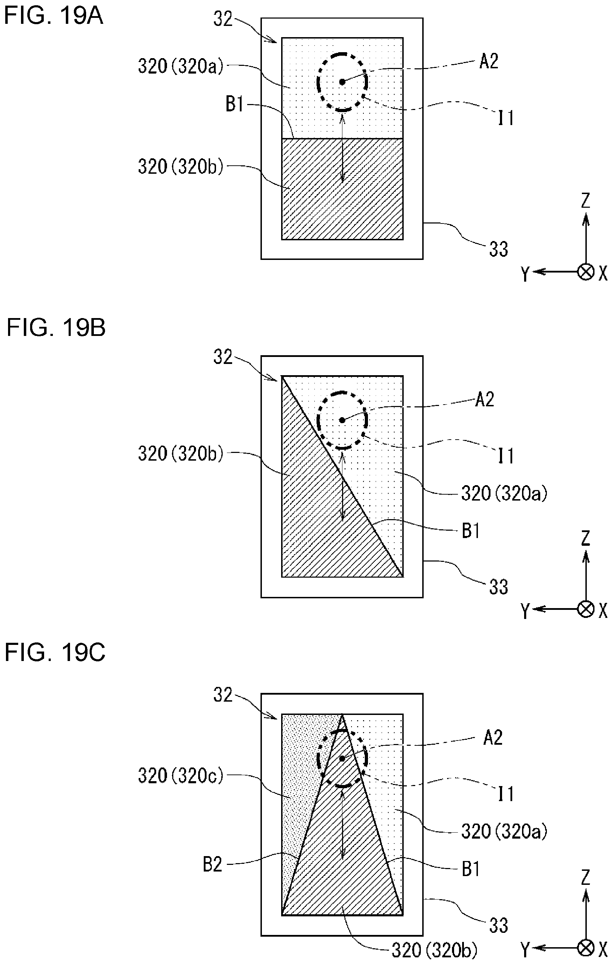

FIGs. 19A to 19C are diagrams of example multiple phosphor areas describing example movement of an illuminating area in a wavelength converter.

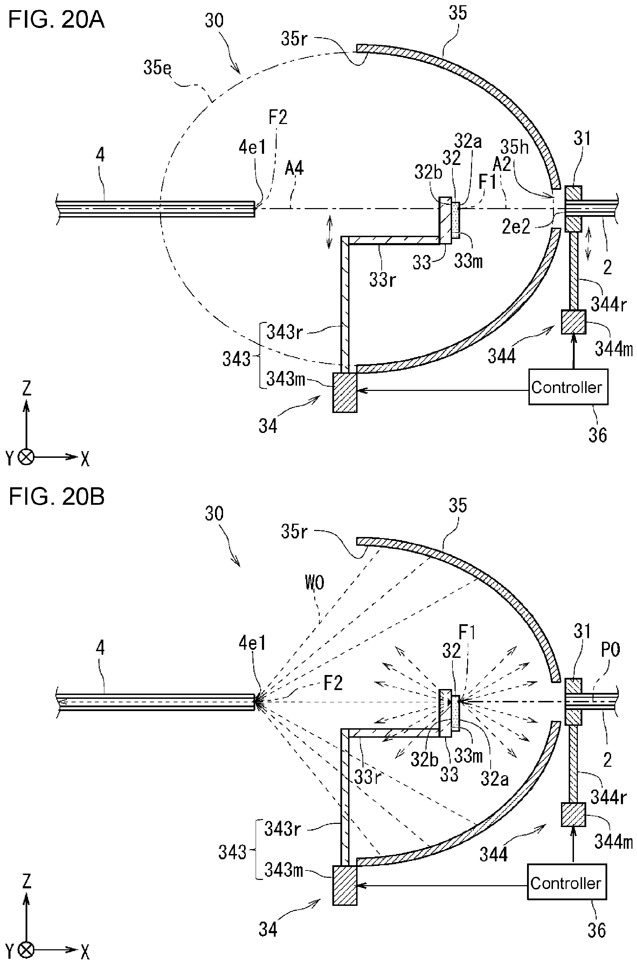

FIG. 20A is a schematic cross-sectional view of a photoconversion device with a fourth structure according to the fifth embodiment, and FIG. 20B is a schematic cross-sectional view of the photoconversion device with the fourth structure according to the fifth embodiment describing conversion of excitation light to fluorescence.

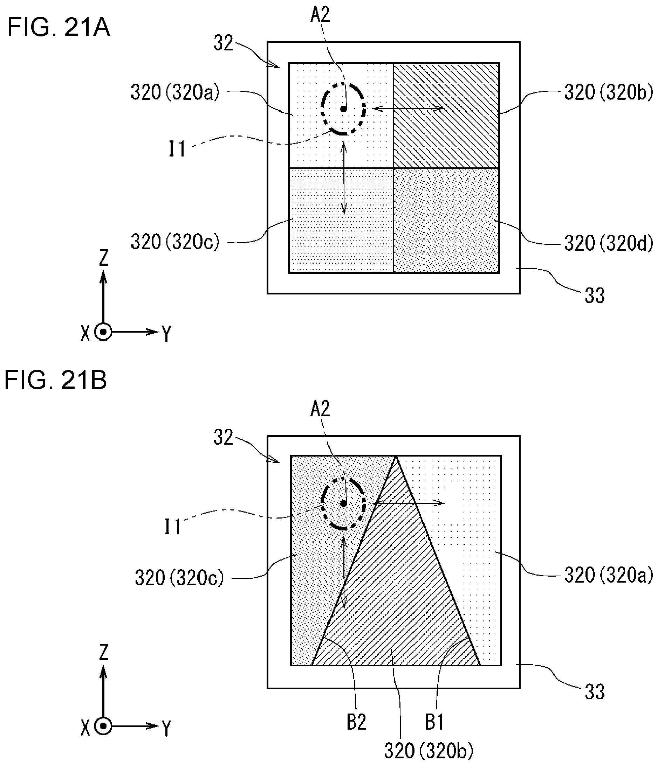

FIGs. 21A and 21B are diagrams of example multiple phosphor areas describing example movement of an illuminating area in a wavelength converter.

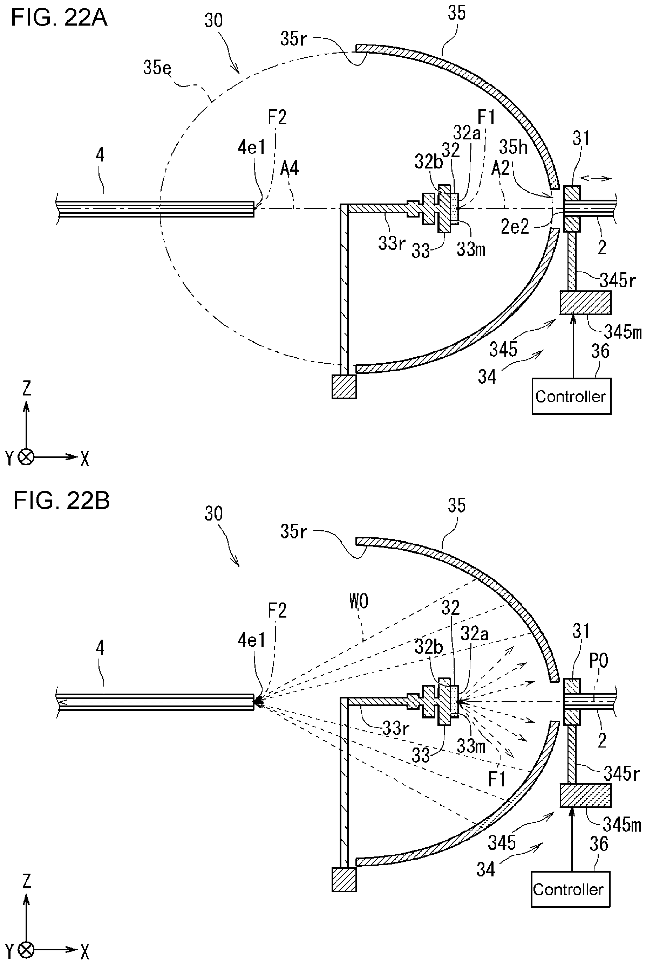

FIG. 22A is a schematic cross-sectional view of a photoconversion device with a first structure according to a sixth embodiment, and FIG. 22B is a schematic cross-sectional view of the photoconversion device with the first structure according to the sixth embodiment describing conversion of excitation light to fluorescence.

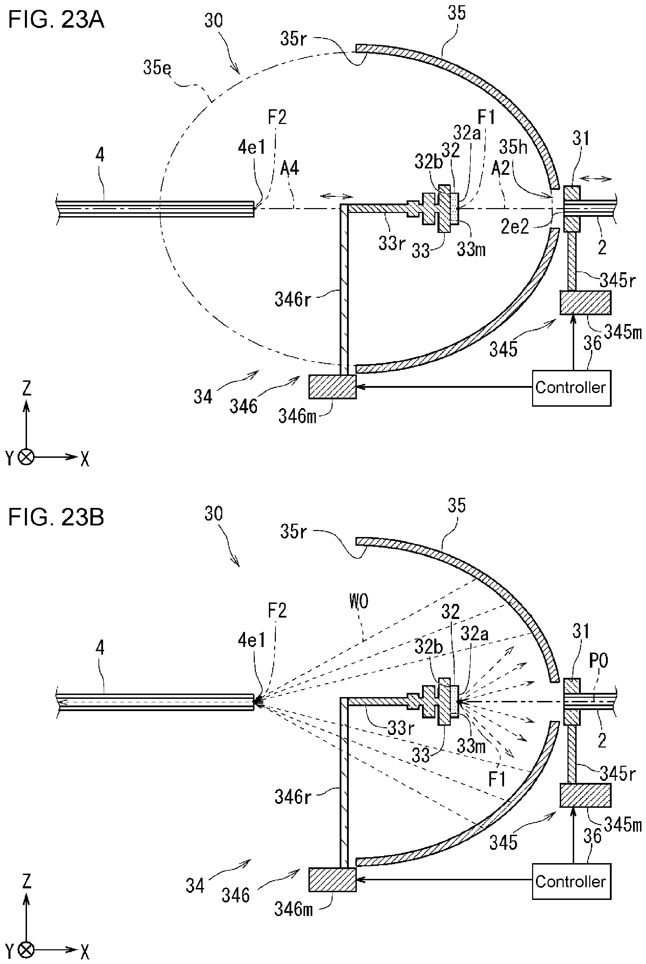

FIG. 23A is a schematic cross-sectional view of a photoconversion device with a second structure according to the sixth embodiment, and FIG. 23B is a schematic cross-sectional view of the photoconversion device with the second structure according to the sixth embodiment describing conversion of excitation light to fluorescence.

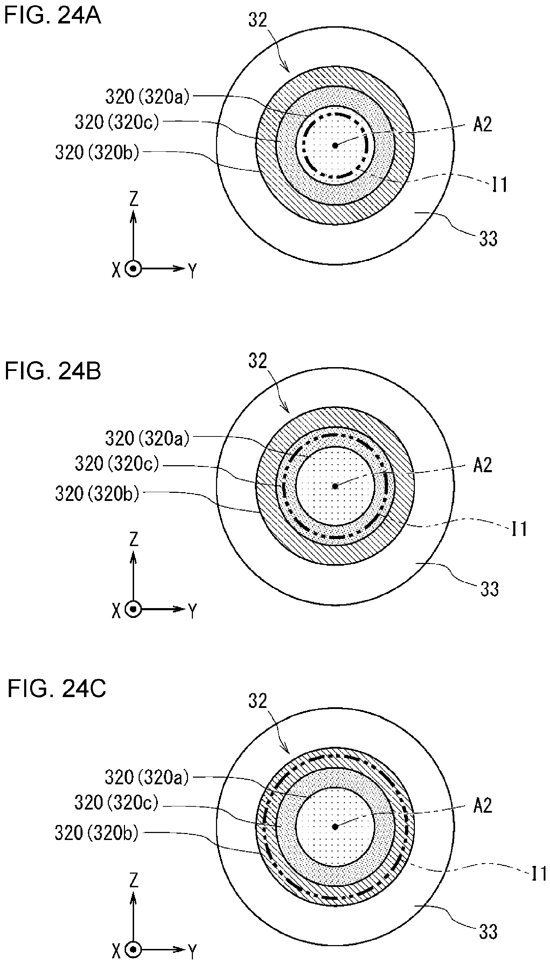

FIGs. 24A to 24C are diagrams of example multiple phosphor areas describing example change of an illuminating area in a wavelength converter.

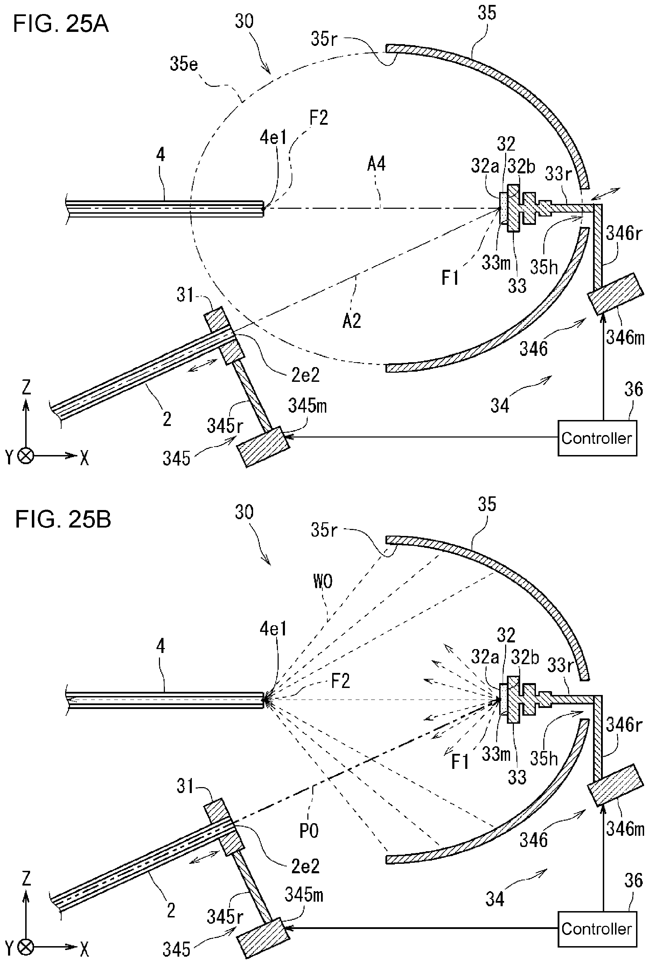

FIG. 25A is a schematic cross-sectional view of a photoconversion device with a third structure according to the sixth embodiment, and FIG. 25B is a schematic cross-sectional view of the photoconversion device with the third structure according to the sixth embodiment describing conversion of excitation light to fluorescence.

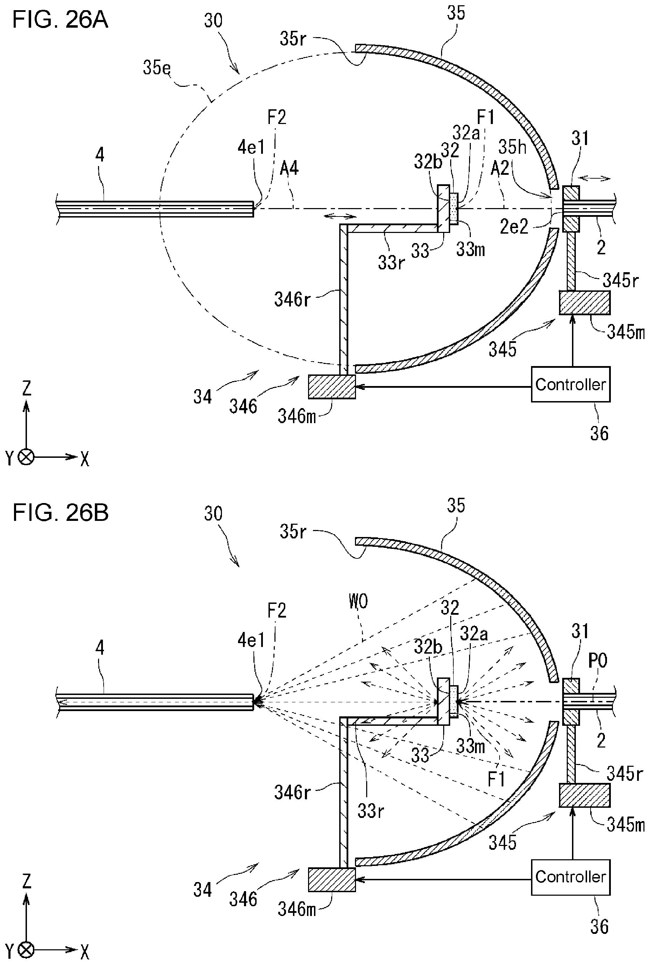

FIG. 26A is a schematic cross-sectional view of a photoconversion device with a fourth structure according to the sixth embodiment, and FIG. 26B is a schematic cross-sectional view of the photoconversion device with the fourth structure according to the sixth embodiment describing conversion of excitation light to fluorescence.

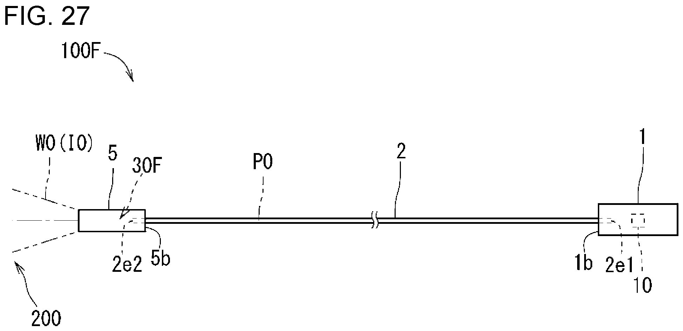

FIG. 27 is a schematic diagram of an example illumination system according to a seventh embodiment.

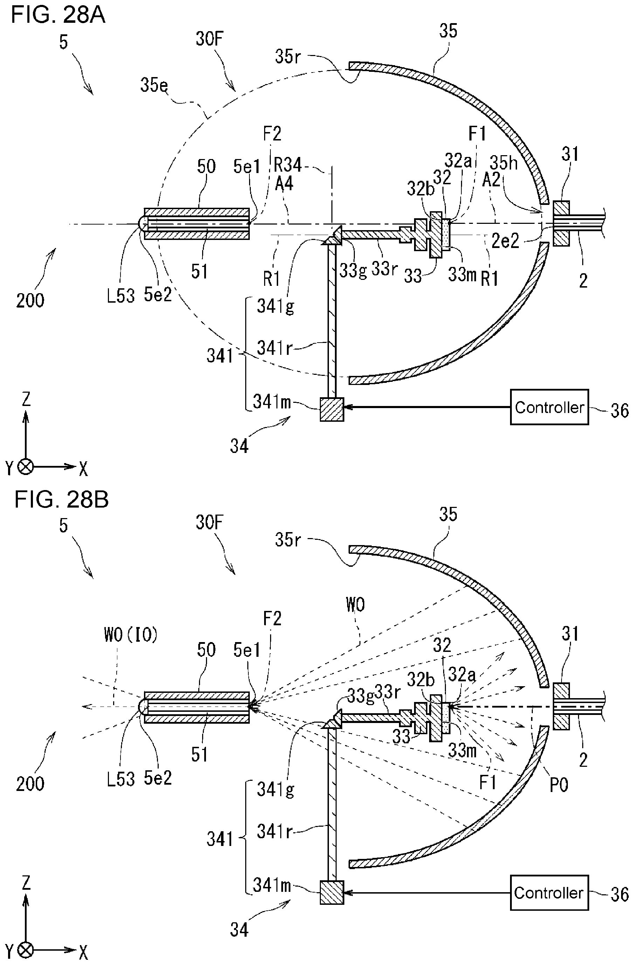

FIG. 28A is a schematic cross-sectional view of an optical radiation module with a first structure according to the seventh embodiment, and FIG. 28B is a schematic cross-sectional view of the optical radiation module with the first structure according to the seventh embodiment describing conversion of excitation light to fluorescence.

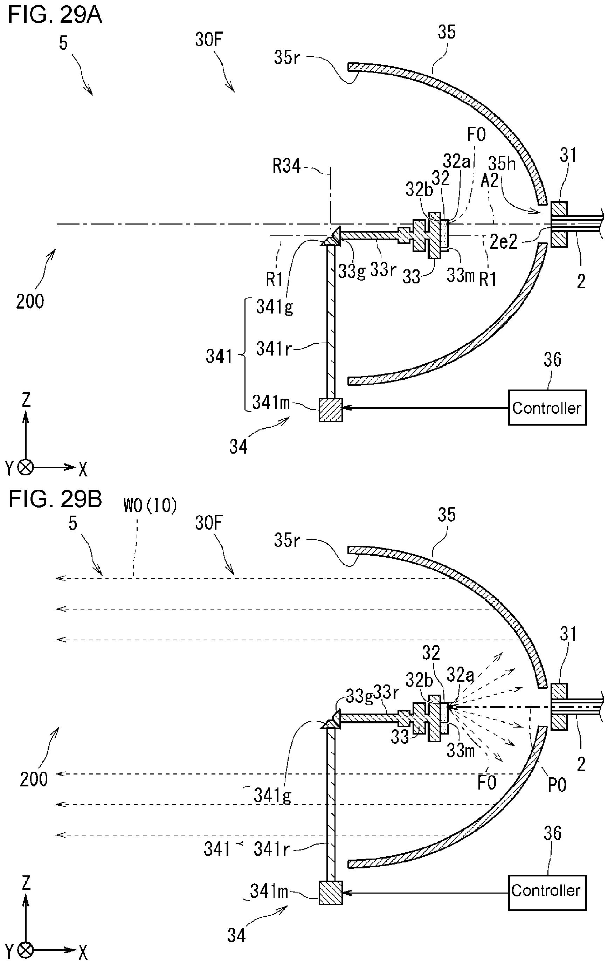

FIG. 29A is a schematic cross-sectional view of an optical radiation module with a second structure according to the seventh embodiment, and FIG. 29B is a schematic cross-sectional view of the optical radiation module with the second structure according to the seventh embodiment describing conversion of excitation light to fluorescence.

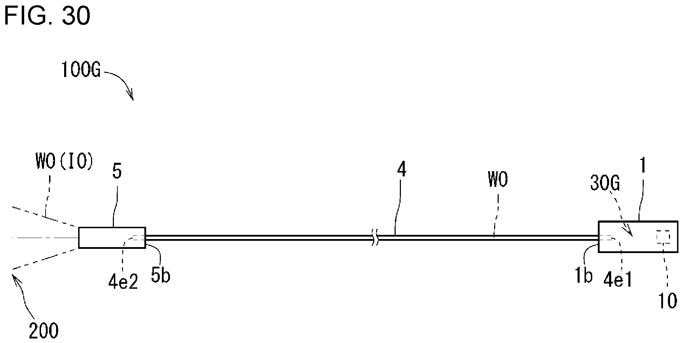

FIG. 30 is a schematic diagram of an example illumination system according to an eighth embodiment.

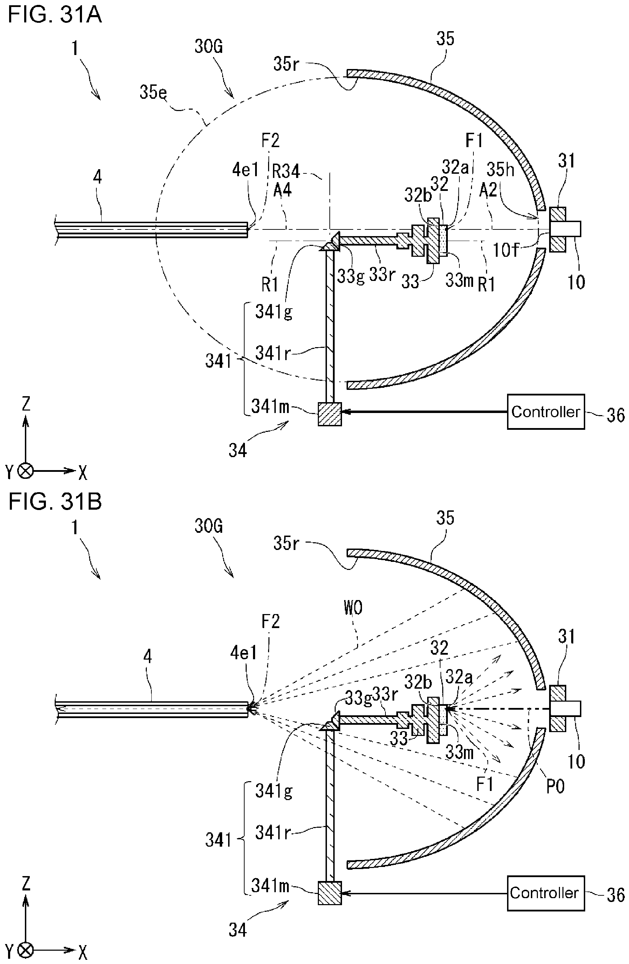

FIG. 31A is a schematic cross-sectional view of a light-emitting module with an example structure according to the eighth embodiment, and FIG. 31B is a schematic cross-sectional view of the light-emitting module with the structure according to the eighth embodiment describing conversion of excitation light to fluorescence.

### DESCRIPTION OF EMBODIMENTS

A known device converts monochromatic light emitted by a light-emitting element to light with a different wavelength using a phosphor substance and emits pseudo white light.

Such devices may use, for example, excitation light emitted by a light-emitting element and applied to phosphors including multiple types of phosphor substances that each emit fluorescence with a specific wavelength (also referred to as a mixture phosphor) to emit light with a color temperature determined in accordance with the characteristics and the mixing ratio of the multiple types of phosphor substances. The color temperature herein may use, for example, the color temperature or the correlated color temperature specified in JIS Z 8725:2015.

However, this structure determines the color temperature of light to be emitted (also referred to as emission light) in accordance with, for example, the characteristics and the mixing ratio of the multiple types of phosphor substances and thus cannot adjust the colors of the emission light.

The emission intensity of two or more of a first light-emitting portion, a second light-emitting portion, and a third light-emitting portion may be controlled to change the color temperature of the emission light. The first light-emitting portion includes a first mixture phosphor that emits fluorescence with a first color temperature in response to excitation light emitted by a first light-emitting element. The second light-emitting portion includes a second mixture phosphor that emits fluorescence with a second color temperature in response to excitation light emitted by a second light-emitting element. The third light-emitting portion includes a third mixture phosphor that emits fluorescence with a third color temperature in response to excitation light emitted by a third light-emitting element.

However, this structure includes, for example, light-emitting elements for the respective phosphors that each emit fluorescence with a different color temperature. These light-emitting elements are then to be controlled. For example, the light emission of each light-emitting element and the intensity of light emitted by each light-emitting element are to be controlled.

Such a photoconversion device is to be improved to, for example, easily adjust the colors of emission light.

The inventors of the present disclosure thus have developed a technique for allowing easy adjustment of the colors of emission light from a photoconversion device and an illumination system including the photoconversion device.

Embodiments of the present disclosure will now be described with reference to the drawings. Throughout the drawings, the components having the same or similar structures and functions are given the same reference numerals, and will not be described repeatedly. The drawings are schematic. FIGs. 2A to 26B, FIGs. 28A to 29B, and FIGs. 31A and 31B illustrate the right-handed XYZ coordinate system. In the XYZ coordinate system, the negative X-direction refers to a direction in which the photoconversion device emits fluorescence W0. The positive Y-direction refers to a direction perpendicular to the negative X-direction, and the positive Z-direction refers to a direction perpendicular to both the negative X-direction and the positive Y-direction.

In FIGs. 2A to 26B, a housing 3b of a relay 3 is not illustrated. In FIGs. 29A and 29B, a housing 5b of an optical radiation module 5 is not illustrated. In FIGs. 31A and 31B, a housing 1b of a light-emitting module 1 is not illustrated. In FIGs. 2B, 6B, 9B, 11B, 13B, 14B, 15B, 16B, 18B, 20B, 22B, 23B, 25B, 26B, 28B, 29B and 31B, arrowed two-dot-dash lines indicate the direction in which excitation light P0 travels, and the direction in which fluorescence W0 travels. In FIGs. 2A, 6A, 9A, 11A, 13A, 14A, 15A, 16A, 18A, 20A, 22A, 23A, 25A, 26A, 28A, and 31A, a thin two-dot chain line indicates the outer edge of an imaginary ellipsoid 35e (described later). In FIGs. 3A to 5C, 7A to 8C, 10A to 10C, 12A to 12C, 17A to 17C, 19A to 19C, 21A, 21B, and 24A to 24C, a thick two-dot chain line indicates the outer edge of an illuminating area I1.

### 1. First Embodiment

### 1-1. Illumination System

As illustrated in FIG. 1, an illumination system 100 according to a first embodiment includes, for example, the light-emitting module 1, a first optical transmission fiber 2, the relay 3, a second optical transmission fiber 4, and the optical radiation module 5.

The light-emitting module 1 can emit, for example, excitation light P0. The light-emitting module 1 includes a light-emitting element 10. The light-emitting element 10 includes, for example, a laser diode (LD) or a light-emitting diode (LED) chip. The excitation light P0 emitted by the light-emitting element 10 is monochromatic light such as violet, blue-violet, or blue light. In the first embodiment, the light-emitting element 10 may be, for example, a gallium nitride (GaN) semiconductor laser that emits violet laser light with 405 nanometers (nm). In the light-emitting module 1, for example, the excitation light P0 emitted by the light-emitting element 10 is directed to be focused at one end 2e1 (also referred to as a first input end) of the first optical transmission fiber 2 by an optical system for focusing light. The light-emitting module 1 includes, for example, the housing 1b accommodating various components.

The first optical transmission fiber 2 can transmit, for example, the excitation light P0 from the light-emitting module 1. In the first embodiment, the first optical transmission fiber 2 extends from the light-emitting module 1 to the relay 3. More specifically, the first optical transmission fiber 2 includes the first input end 2e1 in the longitudinal direction located inside the light-emitting module 1 and another end 2e2 (also referred to as a first output end) opposite to the first input end 2e1 in the longitudinal direction located inside the relay 3. Thus, the first optical transmission fiber 2 provides an optical transmission path for transmitting the excitation light P0 from the light-emitting module 1 to the relay 3. The first optical transmission fiber 2 may be, for example, an optical fiber. The optical fiber includes, for example, a core and a cladding. The cladding surrounds the core and has a lower refractive index of light than the core. In this case, for example, the first optical transmission fiber 2 can transmit the excitation light P0 in the longitudinal direction in the core. The first optical transmission fiber 2 has, in the longitudinal direction, a length of, for example, several tens of centimeters (cm) to several tens of meters (m).

The relay 3 includes, for example, a photoconversion device 30. The photoconversion device 30 can, for example, receive the excitation light P0 transmitted by the first optical transmission fiber 2 and emit fluorescence W0. In the first embodiment, the photoconversion device 30 receives, for example, the excitation light P0 output through the first output end 2e2 of the first optical transmission fiber 2. The first output end 2e2 serves as an output portion. The fluorescence W0 emitted from the photoconversion device 30 in response to the excitation light P0 includes, for example, red (R) light, green (G) light, and blue (B) light. The photoconversion device 30 can thus emit, for example, the fluorescence W0 as pseudo white light in response to the monochromatic excitation light P0. The relay 3 includes, for example, the housing 3b accommodating various components. The housing 3b may include, for example, fins for dissipating heat generated by the photoconversion device 30 as the photoconversion device 30 receives the excitation light P0.

The second optical transmission fiber 4 can transmit, for example, the fluorescence W0 from the relay 3. In the first embodiment, the second optical transmission fiber 4 extends from the relay 3 to the optical radiation module 5. More specifically, the second optical transmission fiber 4 includes one end 4e1 (also referred to as a second input end) in the longitudinal direction located inside the relay 3 and another end 4e2 (also referred to as a second output end) opposite to the second input end 4e1 in the longitudinal direction located inside the optical radiation module 5. Thus, the second optical transmission fiber 4 provides an optical transmission path for transmitting the fluorescence W0 from the relay 3 to the optical radiation module 5. The second optical transmission fiber 4 may be, for example, an optical fiber. The optical fiber includes, for example, a core and a cladding. The cladding surrounds the core and has a lower refractive index of light than the core. In this case, for example, the second optical transmission fiber 4 can transmit the fluorescence W0 in the longitudinal direction in the core. The second optical transmission fiber 4 has, in the longitudinal direction, a length of, for example, several tens of centimeters to ten meters.

The optical radiation module 5 can radiate, for example, the fluorescence W0 transmitted by the second optical transmission fiber 4 into a space 200 outside the illumination system 100 (also referred to as an external space). The optical radiation module 5 illuminates an intended area in the external space 200 with the fluorescence W0 as illumination light I0 through, for example, a lens or a diffuser. The optical radiation module 5 includes, for example, a housing 5b accommodating various components.

In the illumination system 100 with the above structure, for example, the photoconversion device 30 emits fluorescence W0 in response to the excitation light P0 transmitted by the first optical transmission fiber 2 from the light-emitting module 1. This structure can, for example, shorten the distance over which the fluorescence W0 is transmitted by the optical transmission fiber. The structure thus reduces light loss (also referred to as optical transmission loss) that may occur when, for example, the fluorescence W0 travels through the optical transmission fiber in a direction inclined at various angles to the longitudinal direction of the optical transmission fiber and is partly scattered during transmission. Thus, the illumination system 100 can radiate, for example, more fluorescence W0 in response to the excitation light P0. In this example, the optical radiation module 5 does not include the photoconversion device 30. The optical radiation module 5 is, for example, less likely to undergo temperature increase and is easily miniaturized. The structure thus allows, for example, miniaturization of the optical radiation module 5 that radiates the illumination light I0 into the external space 200 of the illumination system 100 while increasing the light intensity of fluorescence W0 emitted from the illumination system 100 in response to the excitation light P0.

### 1-2. Photoconversion Device

As illustrated in FIGs. 2A and 2B, the photoconversion device 30 according to the first embodiment includes, for example, a holder 31, a wavelength converter 32, a drive 34, and a controller 36. These components of the photoconversion device 30 are fixed to a housing 3b of a relay 3 either directly or indirectly with, for example, another member.

The holder 31 holds the first output end 2e2 that serves as an output portion. In the example structure in FIGs. 2A and 2B, the holder 31 holds the first output end 2e2 to cause the excitation light P0 to be emitted in the negative X-direction from the first output end 2e2. In FIG. 2A, a thin dot-dash line segment indicates an optical axis A2 of the first output end 2e2. In FIG. 2B, arrowed two-dot chain lines indicate the traveling direction of the excitation light P0 emitted from the first output end 2e2. The holder 31 includes, for example, a cylindrical portion through which the first output end 2e2 of the first optical transmission fiber 2 is placed. The holder 31 may, for example, hold or be bonded to the outer periphery of the first output end 2e2.

The wavelength converter 32 can emit, for example, fluorescence W0 in response to the excitation light P0 output through the first output end 2e2 as an output portion. The wavelength converter 32 includes, for example, a portion 32a (also referred to as a front portion) to receive the excitation light P0 output through the first output end 2e2 as an output portion, and a portion 32b (also referred to as a rear portion) opposite to the front portion 32a. In the first embodiment, for example, the wavelength converter 32 includes the front portion 32a located in the positive X-direction and the rear portion 32b located in the negative X-direction. The wavelength converter 32 is, for example, a flat plate or a film.

The wavelength converter 32 includes multiple phosphor areas 320 as illustrated in, for example, FIGs. 3A to 3C. In other words, the multiple phosphor areas 320 are arranged in the wavelength converter 32. The multiple phosphor areas 320 include, for example, a first phosphor area 320a and a second phosphor area 320b. In the example structure in FIGs. 3A to 3C, the multiple phosphor areas 320 include the first phosphor area 320a, the second phosphor area 320b, and a third phosphor area 320c. The first phosphor area 320a emits, for example, fluorescence with a first wavelength spectrum in response to the excitation light P0. The second phosphor area 320b emits, for example, fluorescence with a second wavelength spectrum different from the first wavelength spectrum in response to the excitation light P0. The third phosphor area 320c emits, for example, fluorescence with a third wavelength spectrum different from the first wavelength spectrum and the second wavelength spectrum in response to the excitation light P0. The fluorescence with the first wavelength spectrum and the fluorescence with the second wavelength spectrum may have, for example, different color temperatures. The fluorescence with the third wavelength spectrum may be, for example, fluorescence with a color temperature different from the color temperature of fluorescence with the first wavelength spectrum and from the color temperature of fluorescence with the second wavelength spectrum. More specifically, the fluorescence with the first wavelength spectrum may be, for example, light with the first color temperature. The fluorescence with the second wavelength spectrum may be, for example, light with the second color temperature. The fluorescence with the third wavelength spectrum may be, for example, light with the third color temperature. The first color temperature may be, for example, 2650 Kelvin (K). The second color temperature may be, for example, 6500 K. The third color temperature may be 4000 K.

Each phosphor area 320 includes, for example, a solid member including phosphors (also referred to as a phosphor member). The phosphor member may be, for example, a pellet-like member (also referred to as a phosphor pellet) including numerous phosphor particles of multiple types that each emit fluorescence in response to the excitation light P0. The phosphor particles are contained in a transparent material such as resin or glass. In this case, for example, the multiple phosphor areas 320 differ from one another in the ratio of multiple particles. In this manner, the multiple phosphor areas 320 are formed. In this example, the phosphor member may include a transparent substrate, such as a resin or a glass substrate, and phosphor pellets on the substrate. In this case, the multiple phosphor areas 320 may be, for example, arranged on a single substrate.

The multiple types of phosphors include, for example, a phosphor that emits fluorescence of a first color in response to the excitation light P0 and a phosphor that emits fluorescence of a second color different from the first color in response to the excitation light P0. More specifically, the multiple types of phosphors may include, for example, a phosphor that emits red (R) fluorescence in response to the excitation light P0 (also referred to as a red phosphor), a phosphor that emits green (G) fluorescence in response to the excitation light P0 (also referred to as a green phosphor), and a phosphor that emits blue (B) fluorescence in response to the excitation light P0 (also referred to as a blue phosphor). In another example, the multiple types of phosphors may include, for example, a phosphor that emits blue-green fluorescence in response to the excitation light P0 (also referred to as a blue-green phosphor), a phosphor that emits yellow fluorescence in response to the excitation light P0 (also referred to as a yellow phosphor), and other various phosphors that each emit fluorescence with a different color in response to the excitation light P0.

The red phosphor is, for example, a phosphor with a peak wavelength of fluorescence in a range of about 620 to 750 nm emitted in response to the excitation light P0. The red phosphor material is, for example, CaAlSiN₃:Eu, Y₂O₂S:Eu, Y₂O₃:Eu, SrCaClAlSiN₃:Eu²⁺, CaAlSiN₃:Eu, or CaAlSi(ON)₃:Eu. The green phosphor is, for example, a phosphor with a peak wavelength of fluorescence in a range of about 495 to 570 nm emitted in response to the excitation light P0. The green phosphor material is, for example, β-SiAlON:Eu, SrSi₂(O, Cl)₂N₂:Eu, (Sr, Ba, Mg)₂SiO₄:Eu2²⁺, ZnS:Cu, Al, or Zn₂SiO₄:Mn. The blue phosphor is, for example, a phosphor with a peak wavelength of fluorescence in a range of about 450 to 495 nm emitted in response to the excitation light P0. The blue phosphor material is, for example, (Ba, Sr)MgAl₁₀O₁₇:Eu, BaMgAl₁₀O₁₇:Eu, (Sr, Ca, Ba)₁₀(PO₄)₆C₁₂:Eu, or (Sr, Ba)₁₀(PO₄)₆C₁₂:Eu. The blue-green phosphor is, for example, a phosphor with a peak wavelength of fluorescence at about 495 nm emitted in response to the excitation light P0. The blue-green phosphor material is, for example, (Sr, Ba, Ca)₅(PO₄)₃Cl:Eu or Sr₄Al₁₄O₂₅:Eu. The yellow phosphor is, for example, a phosphor with a peak wavelength of fluorescence in a range of about 570 to 590 nm emitted in response to the excitation light P0. The yellow phosphor material is, for example, SrSi₂(O, Cl)₂N₂:Eu. The ratio of the elements in the parentheses herein may be changed as appropriate without deviating from the molecular formulas.

The drive 34 changes, for example, an area (also referred to as an illuminating area) I1 to receive excitation light P0 in the multiple phosphor areas 320. In the example structure in FIGs. 2A and 2B, the drive 34 moves the wavelength converter 32 to change the relative positional relationship between the first output end 2e2 as an output portion and the multiple phosphor areas 320. The drive 34 includes, for example, a unit 341 (also referred to as a first rotator) that rotates the wavelength converter 32 about an imaginary rotation axis R1 (also referred to as a first rotation axis) different from the optical axis A2 of the excitation light P0 that is applied to the wavelength converter 32. In other words, the first rotation axis R1 is an imaginary rotation axis displaced from the optical axis A2 of the excitation light P0.

In the example structure in FIGs. 2A and 2B, the drive 34 moves, for example, a heat sink 33 to which the wavelength converter 32 is joined to change the illuminating area I1 in the multiple phosphor areas 320. The heat sink 33 includes, for example, a portion 33m (also referred to as a joint) to which the wavelength converter 32 is joined, a rod 33r protruding in the negative X-direction from the joint 33m, and a bevel gear 33g fixed to the distal end of the rod 33r in the negative X-direction. The rod 33r is, for example, supported by a housing 3b directly or indirectly with another member and can rotate about the first rotation axis R1 extending in a direction along the X-axis (also referred to as the X-direction). The first rotator 341 includes, for example, a motor 341m, a rod 341r, and a gear 341g. The rod 341r is elongated in a direction along the Z-axis (also referred to as the Z-direction). The rod 341r has its distal end in the positive Z-direction to which, for example, the bevel gear 341g is fixed. The gear 341g meshes with the gear 33g. The motor 341m rotates the rod 341r and the gear 341g about an imaginary rotation axis R34 extending in the Z-direction. Thus, for example, the torque of the gear 341g is transmitted to the gear 33g to rotate the heat sink 33 and the wavelength converter 32 about the first rotation axis R1. As illustrated in FIGs. 3A to 3C, for example, the multiple phosphor areas 320 may rotate about the first rotation axis R1.

The heat sink 33 has, for example, a higher thermal conductivity than the wavelength converter 32. The heat sink 33 can thus cool, for example, the wavelength converter 32 through the rear portion 32b. For example, the rear portion 32b and the joint 33m are in direct contact with each other. For example, phosphor pellets may be formed on the joint 33m on the heat sink 33 using, for example, molding with heat, to directly bond the rear portion 32b of the wavelength converter 32 to the joint 33m on the heat sink 33. For the phosphor pellets containing numerous phosphor particles in glass with a low melting point, for example, the phosphor pellets may be bonded to the joint 33m on the heat sink 33 by sharing oxygen between the phosphor particles and the material for the heat sink 33. The glass with a low melting point may be, for example, a metal oxide that transmits light (also referred to as being transparent) with a melting point of about 400 to 500 degrees Celsius (°C).

When, for example, the joint 33m in the heat sink 33 can reflect light, the excitation light P0 passing through the wavelength converter 32 is reflected from the joint 33m and then enters the wavelength converter 32 again. For example, the joint 33m reflects the fluorescence W0 emitted by the wavelength converter 32 and travelling to the joint 33m. This may increase, for example, the fluorescence W0 emitted by the wavelength converter 32.

The heat sink 33 may be made of, for example, a metal material. The metal material may be, for example, copper (Cu), aluminum (Al), magnesium (Mg), gold (Au), silver (Ag), iron (Fe), chromium (Cr), cobalt (Co), beryllium (Be), molybdenum (Mo), tungsten (W), or an alloy of any of these metals. The heat sink 33 made of, for example, Cu, Al, Mg, Fe, Cr, Co, or Be as the metal material may be fabricated easily by molding, such as die casting. The heat sink 33 made of, for example, Al, Mg, Ag, Fe, Cr, or Co as the metal material may have the joint 33m with a higher reflectance against visible light and increase the light intensity of the fluorescence W0 emitted in response to the excitation light P0. The heat sink 33 may be made of, for example, a nonmetallic material such as silicon nitride (Si₃N₄), carbon (C), or aluminum oxide (Al₂O₃). The nonmetallic material may be, for example, crystalline or non-crystalline. The crystalline nonmetallic material may be, for example, silicon carbide (SiC) or Si₃N₄.

The heat sink 33 may have, as the joint 33m, a layer of a metal material with a higher light reflectance than its main part (also referred to as a high light reflectance layer). For example, the heat sink 33 may contain Cu as the material for the main part, and may contain Ag or Cr, which has a high reflectance against visible light, as the metal material with a high light reflectance. In this case, for example, the main part of the heat sink 33 is fabricated by molding, or for example, by die casting. The surface of the main part then undergoes vapor deposition or plating to form a high light reflectance layer. The high light reflectance layer may include a dielectric multilayer film including dielectric thin films repeatedly stacked on one another. The dielectric may be at least one material selected from, for example, titanium dioxide (TiO₃), silicon dioxide (SiO₂), niobium pentoxide (Nb₂O₅), tantalum pentoxide (Ta₂O₅), or magnesium fluoride (MgF₂).

The controller 36 may drive, for example, the drive 34 to change the illuminating area I1 receiving the excitation light P0 in the multiple phosphor areas 320 and stop driving the drive 34 to define the illuminating area I1 in the multiple phosphor areas 320. In the example structure in FIGs. 2A and 2B, the controller 36 drives the drive 34 to change the relative positional relationship between the first output end 2e2 as an output portion and the multiple phosphor areas 320. In this example, the controller 36 controls, for example, the rotation angle of the motor 341m in the first rotator 341 to control the amount of rotation of the wavelength converter 32 about the first rotation axis R1. The controller 36 detects, for example, the rotation angle of the motor 341m to control the time to stop the motor 341m. The controller 36 is, for example, a control board or a microcomputer. The microcomputer is a large-scale integration circuit (LSI) in which, for example, a central processing unit (CPU) and a memory are integrated. The controller 36, for example, transmits and receives a signal to and from the drive 34 to control the operation of the drive 34. The controller 36 may, for example, control the operation of the drive 34 in response to a signal from a device external to the photoconversion device 30.

In the example of FIGs. 3A to 3C, the wavelength converter 32 is divided into a first phosphor area 320a, a second phosphor area 320b, and a third phosphor area 320c. In this case, for example, the wavelength converter 32 is rotated about the first rotation axis R1 to change the proportions of the multiple phosphor areas 320 in the illuminating area I1. This changes, for example, the wavelength spectrum of fluorescence W0 emitted by the wavelength converter 32 and adjusts the color (also referred to as color adjustment) such as the color temperature of light emitted from the photoconversion device 30 (also referred to as emission light). Thus, the structure can adjust the colors of emission light without increasing the number of light-emitting elements, for example. For example, the photoconversion device 30 can thus easily adjust the colors of emission light.

When, for example, the wavelength converter 32 is viewed in plan in a direction along the first rotation axis R1 as illustrated in FIGs. 3A to 3C, or in other words, in a plan view of the wavelength converter 32 in the direction along the first rotation axis R1, the multiple phosphor areas 320 may be arranged circumferentially about the first rotation axis R1. More specifically, for example, the first phosphor area 320a, the second phosphor area 320b, and the third phosphor area 320c may be arranged in this order circumferentially about the first rotation axis R1. In this case, for example, the wavelength converter 32 is rotated about the first rotation axis R1. This easily changes the proportions of the multiple phosphor areas 320 in the illuminating area I1.

In the example of FIG. 3A, the illuminating area I1 includes the second phosphor area 320b alone. Thus, for example, fluorescence W0 emitted by the wavelength converter 32 is fluorescence with the second color temperature emitted from the second phosphor area 320b. In this case, when, for example, the illuminating area I1 includes the first phosphor area 320a alone, fluorescence W0 emitted by the wavelength converter 32 is fluorescence with the first color temperature emitted from the first phosphor area 320a. When, for example, the illuminating area I1 includes the third phosphor area 320c alone, fluorescence W0 emitted by the wavelength converter 32 is fluorescence with the third color temperature emitted from the third phosphor area 320c. In the example of FIG. 3B, the illuminating area I1 extends across the second phosphor area 320b and the third phosphor area 320c. In this case, for example, fluorescence W0 emitted by the wavelength converter 32 is a mixture of fluorescence with the second color temperature emitted from the second phosphor area 320b and fluorescence with the third color temperature emitted from the third phosphor area 320c. For example, the mixing ratio of the fluorescence having the second color temperature and the fluorescence having the third color temperature may be determined in accordance with, for example, the proportions of the second phosphor area 320b and the third phosphor area 320c in the illuminating area I1. In the example of FIG. 3C, the illuminating area I1 extends across the first phosphor area 320a and the third phosphor area 320c. Thus, for example, fluorescence W0 emitted by the wavelength converter 32 is a mixture of the fluorescence with the first color temperature emitted from the first phosphor area 320a and the fluorescence with the third color temperature emitted from the third phosphor area 320c. For example, the mixing ratio of the fluorescence having the first color temperature and the fluorescence having the third color temperature may be determined in accordance with, for example, the proportions of the first phosphor area 320a and the third phosphor area 320c in the illuminating area I1. When, for example, the illuminating area I1 extends across the first phosphor area 320a and the second phosphor area 320b, the fluorescence W0 emitted by the wavelength converter 32 is a mixture of the fluorescence with the first color temperature emitted from the first phosphor area 320a and the fluorescence with the second color temperature emitted from the second phosphor area 320b. For example, the mixing ratio of the fluorescence having the first color temperature and the fluorescence having the second color temperature may be determined in accordance with, for example, the proportions of the first phosphor area 320a and the second phosphor area 320b in the illuminating area I1.

For example, the wavelength converter 32 may include two, four, or more phosphor areas 320. In other words, the wavelength converter 32 may include, for example, two or more phosphor areas 320. More specifically, as illustrated in FIG. 4A, the wavelength converter 32 may be divided into, for example, the first phosphor area 320a and the second phosphor area 320b. In the example of FIG. 4A, the first phosphor area 320a and the second phosphor area 320b are arranged in this order circumferentially about the first rotation axis R1. As illustrated in FIG. 4B, the wavelength converter 32 may be divided into, for example, the first phosphor area 320a, a fourth phosphor area 320d, a fifth phosphor area 320e, and the second phosphor area 320b. In the example of FIG. 4B, the first phosphor area 320a, the fourth phosphor area 320d, the fifth phosphor area 320e, and the second phosphor area 320b are arranged in this order circumferentially about the first rotation axis R1. The fourth phosphor area 320d emits, for example, fluorescence with a fourth wavelength spectrum in response to the excitation light P0. The fifth phosphor area 320e emits, for example, fluorescence with a fifth wavelength spectrum in response to the excitation light P0. The fluorescence with the fourth wavelength spectrum may be, for example, light with the fourth color temperature. The fluorescence with the fifth wavelength spectrum may be, for example, light with the fifth color temperature. The fourth color temperature may be, for example, 3000 K. The fifth color temperature may be, for example, 5000 K. As illustrated in, for example, FIG. 4C, the wavelength converter 32 may be divided into the first phosphor area 320a, the fourth phosphor area 320d, the third phosphor area 320c, the fifth phosphor area 320e, and the second phosphor area 320b. In the example of FIG. 4C, the first phosphor area 320a, the fourth phosphor area 320d, the third phosphor area 320c, the fifth phosphor area 320e, and the second phosphor area 320b are arranged in this order circumferentially about the first rotation axis R1.

For example, the multiple phosphor areas 320 in the wavelength converter 32 may have substantially the same size or different sizes. In this example, a phosphor area 320 occupying a relatively high proportion of the multiple phosphor areas 320 may be set as appropriate in accordance with intended color tones of illumination light I0 in an environment in which the illumination system 100 is installed. For the illumination light I0 to have a warm color tone, for example, the phosphor area 320 that emits fluorescence with a wavelength spectrum having a warm color temperature may have a larger area size. When the phosphor area 320 occupying a relatively high proportion of the multiple phosphor areas 320 corresponds to a color tone to be used for a long time or frequently, the illuminating area I1 in the phosphor area 320 is changed. The wavelength converter 32 can thus have, for example, a longer service life.

As illustrated in FIGs. 5A to 5C, the first phosphor area 320a may include, for example, an area on the first rotation axis R1 in the wavelength converter 32 and overlaps the illuminating area I1 in the wavelength converter 32. In this case, for example, the first phosphor area 320a is more likely to receive excitation light P0. The photoconversion device 30 is thus used as appropriate for, for example, frequent use of fluorescence with the first wavelength spectrum. In this case, for example, the first wavelength spectrum and the first color temperature of fluorescence emitted from the first phosphor area 320a in response to the excitation light P0 may be set as appropriate in accordance with the wavelength spectrum and the color temperature of frequent use.

In the first embodiment, the photoconversion device 30 includes, for example, a reflector 35.

The reflector 35, for example, surrounds the wavelength converter 32 and reflects fluorescence W0 emitted by the wavelength converter 32. This increases, for example, the light intensity of the fluorescence W0 travelling in an intended direction. In the first embodiment, the reflector 35 includes, for example, a concave reflective surface 35r facing the front portion 32a of the wavelength converter 32. The reflective surface 35r directs, for example, the fluorescence W0 emitted by the wavelength converter 32 to be focused at the second input end 4e1. This can increase, for example, the light intensity of the fluorescence W0 transmitted by the second optical transmission fiber 4.

In the example structure in FIGs. 2A and 2B, the wavelength converter 32 is located between the reflective surface 35r and the second input end 4e1. The reflector 35 herein may be, for example, a parabolic reflector. The reflective surface 35r surrounds, for example, the wavelength converter 32 through the front portion 32a. The reflective surface 35r is concave, for example, in a direction (positive X-direction) from the rear portion 32b to the front portion 32a. The imaginary YZ cross section of the reflective surface 35r is, for example, circular. The imaginary circular cross section of the reflective surface 35r along a YZ plane has a maximum diameter of, for example, about 5 to 6 cm. The reflector 35 includes, for example, a through-hole 35h aligned with the optical axis A2 of the first output end 2e2. The first output end 2e2 thus applies, for example, excitation light P0 to the wavelength converter 32. The first output end 2e2 may be placed into, for example, the through-hole 35h.

The reflector 35 may be, for example, an ellipsoidal mirror with the reflective surface 35r along the imaginary ellipsoid 35e. In this case, for example, a first focal point F1 of the imaginary ellipsoid 35e located at a point along the wavelength converter 32 allows fluorescence W0 emitted by the wavelength converter 32 to be focused on a second focal point F2 different from the first focal point F1 of the imaginary ellipsoid 35e. For example, the second focal point F2 aligned with the second input end of the second optical transmission fiber 4 may increase the light intensity of the fluorescence W0 incident on the second optical transmission fiber 4. In the relay 3, the second optical transmission fiber 4 is located, for example, along a linear imaginary line A4 passing through the first focal point F1 and the second focal point F2.

### 1-3. Overview of First Embodiment

In the photoconversion device 30 according to the first embodiment, for example, the drive 34 is driven to change the illuminating area I1 receiving the excitation light P0 in the multiple phosphor areas 320 and stop driving the drive 34 to define the illuminating area I1 in the multiple phosphor areas 320. This changes, for example, the wavelength spectrum of fluorescence W0 emitted by the wavelength converter 32 to adjust the colors of light emitted from the photoconversion device 30. Thus, the structure can adjust the colors of emission light without increasing the number of light-emitting elements, for example. The photoconversion device 30 can thus, for example, easily adjust the colors of emission light.

### 2. Other Embodiments

The present disclosure is not limited to the above first embodiment and may be changed or varied without departing from the spirit and scope of the present disclosure.

### 2-1. Second Embodiment

In the above first embodiment, the drive 34 may move, for example, the holder 31 to change the relative positional relationship between the first output end 2e2 as an output portion and the multiple phosphor areas 320 as illustrated in FIGs. 6A and 6B. In other words, the drive 34 may move, for example, a part of at least one of the holder 31 or the wavelength converter 32 to change the relative positional relationship between the first output end 2e2 as an output portion and the multiple phosphor areas 320. In this structure as well, the controller 36 may drive, for example, the drive 34 to change the illuminating area I1 receiving the excitation light P0 in the multiple phosphor areas 320 and stop driving the drive 34 to define the illuminating area I1 in the multiple phosphor areas 320.

In a photoconversion device 30 with an example structure according to a second embodiment illustrated in FIGs. 6A and 6B, the drive 34 includes, for example, a unit 342 (also referred to as a second rotator) that rotates the holder 31 about an imaginary rotation axis R2 (also referred to as a second rotation axis) different from the optical axis A2. In other words, the second rotation axis R2 is an imaginary rotation axis displaced from the optical axis A2. The second rotator 342 includes, for example, a motor 342m and a rod 342r. The rod 342r is elongated in the X-direction. The rod 342r has its distal end in the negative X-direction to which, for example, the holder 31 is fixed. The motor 342m rotates, for example, the rod 342r about the second rotation axis R2 extending in the X-direction. Thus, for example, the holder 31 and the first output end 2e2 may rotate about the second rotation axis R2. The heat sink 33 is held, for example, directly by the housing 3b or indirectly with another member. As illustrated in FIGs. 7A to 7C, for example, the illuminating area I1 may rotate about the second rotation axis R2 in the multiple phosphor areas 320. For example, the illuminating area I1 in the multiple phosphor areas 320 may thus be changed. In this case as well, for example, the photoconversion device 30 can easily adjust the colors of emission light as in the above first embodiment.

When, for example, the wavelength converter 32 is viewed in plan in a direction along the second rotation axis R2 as illustrated in FIGs. 7A to 7C, or in other words, in a plan view of the wavelength converter 32 in the direction along the second rotation axis R2, the multiple phosphor areas 320 may be arranged circumferentially about the second rotation axis R2. More specifically, for example, the first phosphor area 320a, the second phosphor area 320b, and the third phosphor area 320c may be arranged in this order circumferentially about the second rotation axis R2. In this case, when, for example, the holder 31 and the first output end 2e2 are rotated about the second rotation axis R2, the proportions of the multiple phosphor areas 320 in the illuminating area I1 may be changed easily.

As illustrated in FIGs. 8A to 8C, the first phosphor area 320a may include, for example, an area on the second rotation axis R2 in the wavelength converter 32 and overlaps the illuminating area I1 in the wavelength converter 32. In this case, for example, the first phosphor area 320a is more likely to receive excitation light P0. The photoconversion device 30 is thus used as appropriate for, for example, frequent use of fluorescence with the first wavelength spectrum. In this case, for example, the first wavelength spectrum and the first color temperature of fluorescence emitted from the first phosphor area 320a in response to the excitation light P0 may be set as appropriate in accordance with the wavelength spectrum and the color temperature of frequent use.

### 2-2. Third Embodiment

In the above first embodiment, for example, the wavelength converter 32 may include the front portion 32a located in the negative X-direction and the rear portion 32b located in the positive X-direction, and the holder 31 may hold the first output end 2e2 to apply excitation light P0 obliquely to the front portion 32a as illustrated in FIGs. 9A and 9B. In this case as well, the drive 34 changes, for example, the illuminating area I1 in the multiple phosphor areas 320. The controller 36 may drive the drive 34 to change the illuminating area I1 receiving the excitation light P0 in the multiple phosphor areas 320 and stop driving the drive 34 to define the illuminating area I1 in the multiple phosphor areas 320.

Also in a photoconversion device 30 with a first structure according to a third embodiment illustrated in FIGs. 9A and 9B, the drive 34 moves the wavelength converter 32 to change the relative positional relationship between the first output end 2e2 as an output portion and the multiple phosphor areas 320. The drive 34 includes, for example, the first rotator 341 that rotates the wavelength converter 32 about the first rotation axis R1 different from the optical axis A2 of excitation light P0 applied to the wavelength converter 32. In other words, the drive 34 includes, for example, the first rotator 341 that rotates the wavelength converter 32 about the first rotation axis R1 displaced from the optical axis A2 of excitation light P0 applied to the wavelength converter 32.

For example, the drive 34 moves the heat sink 33 to which the wavelength converter 32 is joined to change the illuminating area I1 in the multiple phosphor areas 320. The heat sink 33 includes, for example, the joint 33m to which the wavelength converter 32 is joined and the rod 33r protruding in the positive X-direction from the joint 33m. The first rotator 341 includes, for example, the motor 341m. The motor 341m rotates the rod 33r about the first rotation axis R1. Thus, for example, the heat sink 33 and the wavelength converter 32 may rotate about the first rotation axis R1. As illustrated in FIGs. 10A to 10C, for example, the multiple phosphor areas 320 may thus rotate about the first rotation axis R1.

As illustrated in FIGs. 10A to 10C, the wavelength converter 32 is divided into, for example, the first phosphor area 320a, the second phosphor area 320b, and the third phosphor area 320c. Thus, for example, the wavelength converter 32 is rotated about the first rotation axis R1 to change the proportions of the multiple phosphor areas 320 in the illuminating area I1. This changes, for example, the wavelength spectrum of fluorescence W0 emitted by the wavelength converter 32 to adjust the colors of emission light from the photoconversion device 30. The structure can adjust the colors of emission light without increasing the number of light-emitting elements, for example. The photoconversion device 30 can easily adjust the colors of emission light. When, for example, the wavelength converter 32 is viewed in plan in the direction along the first rotation axis R1 as illustrated in FIGs. 10A to 10C, or in other words, in a plan view of the wavelength converter 32 in the direction along the first rotation axis R1, the multiple phosphor areas 320 are arranged circumferentially about the first rotation axis R1. In this case, the wavelength converter 32 is rotated about the first rotation axis R1. This easily changes the proportions of the multiple phosphor areas 320 in the illuminating area I1.

In the above second embodiment, for example, the wavelength converter 32 may include the front portion 32a located in the negative X-direction and the rear portion 32b located in the positive X-direction, and the holder 31 may hold the first output end 2e2 to apply the excitation light P0 obliquely to the front portion 32a as illustrated in FIGs. 11A and 11B. In this case as well, the drive 34 changes, for example, the illuminating area I1 in the multiple phosphor areas 320. In a photoconversion device 30 with a second structure according to the third embodiment in FIGs. 11A and 11B as well, the drive 34 moves the holder 31 to change the relative positional relationship between the first output end 2e2 as an output portion and the multiple phosphor areas 320. The drive 34 includes, for example, the second rotator 342 that rotates the holder 31 about the second rotation axis R2 that is different from the optical axis A2. In other words, the drive 34 includes, for example, the second rotator 342 that rotates the holder 31 about the second rotation axis R2 displaced from the optical axis A2.

The second rotator 342 includes, for example, the motor 342m and the rod 342r. The rod 342r is elongated along the optical axis A2. The rod 342r has its distal end to which, for example, the holder 31 is fixed. The motor 342m rotates, for example, the rod 342r about the second rotation axis R2 displaced in parallel to the optical axis A2. Thus, for example, the holder 31 and the first output end 2e2 may rotate about the second rotation axis R2. As illustrated in FIGs. 12A to 12C, for example, the illuminating area I1 may rotate about the second rotation axis R2 in the multiple phosphor areas 320.

As illustrated in FIGs. 12A to 12C, the wavelength converter 32 is divided into, for example, the first phosphor area 320a, the second phosphor area 320b, and the third phosphor area 320c. Thus, when, for example, the holder 31 is rotated about the second rotation axis R2, the proportions of the multiple phosphor areas 320 in the illuminating area I1 are changed. This changes, for example, the wavelength spectrum of fluorescence W0 emitted by the wavelength converter 32 to adjust the colors of emission light from the photoconversion device 30. The structure can adjust the colors of emission light without increasing the number of light-emitting elements, for example. The photoconversion device 30 can easily adjust the colors of emission light. When, for example, the wavelength converter 32 is viewed in plan in the direction along the second rotation axis R2 as illustrated in FIGs. 12A to 12C, or in other words, in a plan view of the wavelength converter 32 in the direction along the second rotation axis R2, the multiple phosphor areas 320 are arranged circumferentially about the second rotation axis R2. In this case, the holder 31 and the first output end 2e2 are rotated about the second rotation axis R2. This easily changes the proportions of the multiple phosphor areas 320 in the illuminating area I1.

### 2-3. Fourth Embodiment

In the above first embodiment, the heat sink 33 may be, for example, a transparent member as illustrated in FIGs. 13A and 13B. In the above second embodiment, the heat sink 33 may be, for example, a transparent member as illustrated in FIGs. 14A and 14B. In this case, for example, the wavelength converter 32 emits fluorescence W0 from both the front portion 32a and the rear portion 32b.

In a photoconversion device 30 with a first structure according to a fourth embodiment illustrated in FIGs. 13A and 13B, the heat sink 33 includes, for example, a transparent substrate connected to the rod 33r being transparent. In a photoconversion device 30 with a second structure according to the fourth embodiment illustrated in FIGs. 14A and 14B, the heat sink 33 is, for example, a substrate.

The heat sink 33 is, for example, a transparent member (also referred to as a highly thermally conductive transparent member) with high thermal conductivity. The highly thermally conductive transparent member may be made of, for example, a single-crystal inorganic oxide. Examples of the single-crystal inorganic oxide include sapphire and magnesia. For example, phosphor pellets can be formed on the substrate of the highly thermally conductive transparent member by molding with heat to cause the rear portion 32b of the wavelength converter 32 and the highly thermally conductive transparent member to be in contact with each other. For the phosphor pellets containing numerous particles of multiple types of phosphors in glass with a low melting point, for example, the phosphor pellets may be joined to the highly thermally conductive transparent member by sharing oxygen between the phosphor particles and the material for the highly thermally conductive transparent member. The heat sink 33 may be made of, for example, glass or a single-crystal aluminum nitride (AlN).

For example, the highly thermally conductive transparent member may be located on the front portion 32a of the wavelength converter 32. In the example structure in FIGs. 14A and 14B, the heat sink 33 may be located on the front portion 32a rather than on the rear portion 32b.

### 2-4. Fifth Embodiment

In the above first to fourth embodiments, for example, the drive 34 may include a unit (also referred to as a first mover) for moving the wavelength converter 32 and the holder 31 relative to each other in a direction (also referred to as a first intersecting direction) intersecting with the optical axis A2 of excitation light P0. In this case as well, the controller 36 may drive the drive 34 to change the illuminating area I1 receiving the excitation light P0 in the multiple phosphor areas 320 and stop driving the drive 34 to define the illuminating area I1 in the multiple phosphor areas 320. This changes, for example, the wavelength spectrum of fluorescence W0 emitted by the wavelength converter 32 to adjust the colors of emission light from the photoconversion device 30.

In a photoconversion device 30 with a first structure according to a fifth embodiment illustrated in FIGs. 15A and 15B, the drive 34 includes a first linear mover 343 as an example first mover for moving the wavelength converter 32 in the Z-direction as the first intersecting direction. The first linear mover 343 includes, for example, a rod 343r and a driver 343m. The rod 343r is connected to, for example, the rod 33r in the heat sink 33. The driver 343m moves, for example, the rod 343r in the Z-direction. The driver 343m includes, for example, a motor and a ball screw. In this example, the driver 343m moves the rod 343r in the Z-direction to move the heat sink 33 and the wavelength converter 32 in the Z-direction. The controller 36 controls, for example, the degree of movement and the position of the wavelength converter 32 in the Z-direction by controlling the rotational speed of the motor included in the driver 343m. The controller 36 may control the time to stop the motor by, for example, detecting the rotational speed of the motor in the driver 343m. The driver 343m may include, for example, an actuator selected from various actuators. Although the rod 343r has one supported end in the longitudinal direction in the example of FIGs. 15A and 15B, the rod 343r may have two supported ends in the longitudinal direction.

In a photoconversion device 30 with a second structure according to the fifth embodiment illustrated in FIGs. 16A and 16B, the drive 34 includes a second linear mover 344 as the first mover for moving the holder 31 in the Z-direction as the first intersecting direction. The second linear mover 344 includes, for example, a rod 344r and a driver 344m. The rod 344r is connected to, for example, the holder 31. The driver 344m moves, for example, the rod 344r in the Z-direction. The driver 344m includes, for example, a motor and a ball screw. In this example, the driver 344m moves the rod 344r in the Z-direction to move the holder 31 and the first output end 2e2 in the Z-direction. The controller 36 controls, for example, the rotational speed of the motor included in the driver 344m to control the degree of movement and the position of the holder 31 in the Z-direction. The controller 36 may control the time to stop the motor by, for example, detecting the rotational speed of the motor in the driver 344m. The driver 344m may include, for example, an actuator selected from various actuators. Although the rod 344r has one supported end in the longitudinal direction in the example of FIGs. 16A and 16B, the rod 344r may have two supported ends in the longitudinal direction. For example, the photoconversion device 30 may include at least one of the first linear mover 343 or the second linear mover 344.

In the example of FIG. 17A, the wavelength converter 32 includes the multiple phosphor areas 320 including the first phosphor area 320a and the second phosphor area 320b. In this example, the wavelength converter 32 is divided into the first phosphor area 320a and the second phosphor area 320b as illustrated in FIG. 17A. When, for example, at least one of the wavelength converter 32 or the holder 31 is moved in the Z-direction as the first intersecting direction, the proportions of the multiple phosphor areas 320 in the illuminating area I1 are changed. This changes, for example, the wavelength spectrum of fluorescence W0 emitted by the wavelength converter 32 to adjust the colors of emission light from the photoconversion device 30.

When, for example, the wavelength converter 32 is viewed in plan in a direction along the optical axis A2 of excitation light P0 as illustrated in FIG. 17A, or in other words, in a plan view of the wavelength converter 32 in the direction along the optical axis A2 of excitation light P0, the multiple phosphor areas 320 may be arranged in the Z-direction as the first intersecting direction. In the example of FIG. 17A, the first phosphor area 320a and the second phosphor area 320b are arranged in the negative Z-direction in this order. In this case, for example, at least one of the wavelength converter 32 or the holder 31 is moved relative to each other in the Z-direction as the first intersecting direction to move the illuminating area I1 in the multiple phosphor areas 320. For example, the illuminating area I1 in the multiple phosphor areas 320 may thus be changed easily. In the example of FIG. 17A, the illuminating area I1 includes the first phosphor area 320a alone. Thus, for example, fluorescence W0 emitted by the wavelength converter 32 is fluorescence with the first color temperature emitted from the first phosphor area 320a. When, for example, at least one of the wavelength converter 32 or the holder 31 is moved relative to each other in the Z-direction as the first intersecting direction to move the illuminating area I1 relative to the wavelength converter 32 in the negative Z-direction, the illuminating area I1 extends across the first phosphor area 320a and the second phosphor area 320b. In this case, for example, fluorescence W0 emitted by the wavelength converter 32 is a mixture of fluorescence with the first color temperature emitted from the first phosphor area 320a and fluorescence with the second color temperature emitted from the second phosphor area 320b. For example, the mixing ratio of the fluorescence having the first color temperature and the fluorescence having the second color temperature may be determined in accordance with, for example, the proportions of the first phosphor area 320a and the second phosphor area 320b in the illuminating area I1. When, for example, at least one of the wavelength converter 32 or the holder 31 is moved relative to each other in the Z-direction as the first intersecting direction to move the illuminating area I1 relative to the wavelength converter 32 in the negative Z-direction, the illuminating area I1 includes the second phosphor area 320b alone. Thus, for example, fluorescence W0 emitted by the wavelength converter 32 is fluorescence with the second color temperature emitted from the second phosphor area 320b.

When, for example, the wavelength converter 32 is viewed in plan in the direction along the optical axis A2 of excitation light P0 as illustrated in FIG. 17B, or in other words, in a plan view of the wavelength converter 32 in the direction along the optical axis A2 of the excitation light P0, a boundary B1 between the first phosphor area 320a and the second phosphor area 320b may extend obliquely to the Z-direction as the first intersecting direction. Thus, for example, the change amount of proportions of the first phosphor area 320a and the second phosphor area 320b in the illuminating area I1 is smaller than the degree of movement of the illuminating area I1 in the multiple phosphor areas 320. This allows, for example, the proportions of areas, in the first phosphor area 320a and the second phosphor area 320b, to receive excitation light P0 to be changed precisely. For example, the photoconversion device 30 can thus precisely adjust the colors of emission light.

For example, the wavelength converter 32 may include three or more phosphor areas 320. In other words, the wavelength converter 32 may include, for example, two or more phosphor areas 320. More specifically, the wavelength converter 32 is divided into, for example, the first phosphor area 320a, the second phosphor area 320b, and the third phosphor area 320c as illustrated in FIG. 17C. In the example of FIG. 17C, the first phosphor area 320a and the second phosphor area 320b are arranged in the negative Z-direction in this order, and the third phosphor area 320c and the second phosphor area 320b are arranged in the negative Z-direction in this order. In the example of FIG. 17C, the boundary B1 between the first phosphor area 320a and the second phosphor area 320b and a boundary B2 between the third phosphor area 320c and the second phosphor area 320b extend obliquely to the Z-direction as the first intersecting direction.

In the above fifth embodiment, for example, the wavelength converter 32 may include the front portion 32a located in the negative X-direction and the rear portion 32b located in the positive X-direction, and the holder 31 may hold the first output end 2e2 to apply excitation light P0 obliquely to the front portion 32a as illustrated in FIGs. 18A and 18B. In a photoconversion device 30 with a third structure according to the fifth embodiment, the heat sink 33 extends from the rear portion 32b of the wavelength converter 32 in the positive X-direction, and the rod 33r extends in the positive X-direction.

When, for example, the wavelength converter 32 is divided into the first phosphor area 320a and the second phosphor area 320b as illustrated in FIG. 19A, at least one of the wavelength converter 32 or the holder 31 is moved relative to each other in the Z-direction as the first intersecting direction to change the proportions of the multiple phosphor areas 320 in the illuminating area I1. This changes, for example, the wavelength spectrum of fluorescence W0 emitted by the wavelength converter 32 to adjust the colors of emission light from the photoconversion device 30. More specifically, when, for example, the wavelength converter 32 is viewed in plan in the direction along the optical axis A2 of excitation light P0 as illustrated in FIG. 19A, or in other words, in a plan view of the wavelength converter 32 in the direction along the optical axis A2 of excitation light P0, the multiple phosphor areas 320 may be arranged in the Z-direction as the first intersecting direction. In the example of FIG. 19A, the first phosphor area 320a and the second phosphor area 320b are arranged in this order in the negative Z-direction. When, for example, the wavelength converter 32 or the holder 31 is moved in the Z-direction as the first intersecting direction, the illuminating area I1 in the multiple phosphor areas 320 may be changed easily. When, for example, the wavelength converter 32 is viewed in plan in the direction along the optical axis A2 of the excitation light P0 as illustrated in FIG. 19B, or in other words, in a plan view of the wavelength converter 32 in the direction along the optical axis A2 of excitation light P0, the boundary B1 between the first phosphor area 320a and the second phosphor area 320b may extend obliquely to the Z-direction as the first intersecting direction. This allows, for example, the proportions of areas, in the first phosphor area 320a and the second phosphor area 320b, to receive excitation light P0 to be changed precisely. For example, the photoconversion device 30 may thus precisely adjust the colors of emission light. For example, the wavelength converter 32 may include three or more phosphor areas 320 as illustrated in FIG. 19C. In other words, the wavelength converter 32 may include, for example, two or more phosphor areas 320.

The multiple phosphor areas 320 may have substantially the same size or different sizes. In this example, a phosphor area 320 occupying a relatively high proportion of the multiple phosphor areas 320 may be set as appropriate in accordance with intended color tones of illumination light I0 in an environment in which the illumination system 100 is installed. When, for example, illumination light I0 is to be a bluish color tone, the phosphor area that emits fluorescence with a wavelength spectrum having a bluish color temperature may be larger. When, for example, illumination light I0 is to be a reddish color tone, the phosphor area that emits fluorescence with a wavelength spectrum having a color temperature corresponding to the reddish color tone may be larger. When the phosphor area 320 occupying a relatively high proportion of the multiple phosphor areas 320 corresponds to a color tone to be used for a long time or frequently, the illuminating area I1 in the phosphor area 320 is changed. The wavelength converter 32 can thus have, for example, a longer service life.

In the fifth embodiment, the heat sink 33 may be, for example, a transparent member as illustrated in FIGs. 20A and 20B. In this case, for example, the wavelength converter 32 emits fluorescence W0 from both the front portion 32a and the rear portion 32b. In a photoconversion device 30 with a fourth structure according to the fifth embodiment illustrated in FIGs. 20A and 20B, the heat sink 33 includes, for example, a transparent substrate connected to the rod 33r being transparent. The heat sink 33 is, for example, a transparent member with high thermal conductivity (highly thermally conductive transparent member). For example, the highly thermally conductive transparent member may be located on the front portion 32a of the wavelength converter 32.

In the photoconversion devices 30 with the second to fourth structures according to the above fifth embodiment, for example, at least one of the first linear mover 343 or the second linear mover 344 may move the wavelength converter 32 and the holder 31 relative to each other in a direction (also referred to as a second intersecting direction) intersecting not only the first intersecting direction but also the optical axis A2. In this case, for example, in a direction along the Y-axis (also referred to as Y-direction) as the second intersecting direction, the first linear mover 343 may move the wavelength converter 32, or the second linear mover 344 may move the holder 31. For example, the first linear mover 343 may move the driver 343m along a linear guide extending in the Y-direction with a combination of the ball screw and the motor or the actuators. For example, the second linear mover 344 may move the driver 344m along a linear guide extending in the Y-direction with a combination of the ball screw and the motor or the actuators.

When, for example, the wavelength converter 32 is viewed in plan in the direction along the optical axis A2 of excitation light P0 as illustrated in FIG. 21A, or in other words, in a plan view of the wavelength converter 32 in the direction along the optical axis A2 of excitation light P0, the multiple phosphor areas 320 may be arranged in the Z-direction as the first intersecting direction and in the Y-direction as the second intersecting direction. Thus, for example, the controller 36 controls the operation of the drive 34 to freely change the proportions of the multiple phosphor areas 320 in the illuminating area I1. When, for example, the wavelength converter 32 is viewed in plan in the direction along the optical axis A2 of excitation light P0 as illustrated in FIG. 21B, the boundary B1 between the first phosphor area 320a and the second phosphor area 320b and the boundary B2 between the second phosphor area 320b and the third phosphor area 320c may extend obliquely to the Z-direction as the first intersecting direction and the Y-direction as the second intersecting direction. This allows, for example, the proportions of the multiple phosphor areas 320 in the illuminating area I1 to be changed precisely. For example, the photoconversion device 30 may thus precisely adjust the colors of emission light.

### 2-5. Sixth Embodiment

In the above first to fifth embodiments, for example, the drive 34 may include a unit (also referred to as a second mover) for changing the distance between the holder 31 and the wavelength converter 32 in the direction (also referred to as an optical axis direction) along the optical axis A2 of excitation light P0. In this case, for example, the drive 34 changes the distance between the first output end 2e2 as an output portion and the wavelength converter 32 to change the size of the illuminating area I1. For example, the drive 34 thus changes the illuminating area I1 of excitation light P0 in the multiple phosphor areas 320. In this case as well, the controller 36 may drive the drive 34 to change the illuminating area I1 receiving the excitation light P0 in the multiple phosphor areas 320 and stop driving the drive 34 to define the illuminating area I1 in the multiple phosphor areas 320. This changes, for example, the wavelength spectrum of fluorescence W0 emitted by the wavelength converter 32 to adjust the colors of emission light from the photoconversion device 30.

In a photoconversion device 30 with a first structure according to a sixth embodiment illustrated in FIGs. 22A and 22B, the drive 34 includes a third linear mover 345 as an example second mover for moving the holder 31 in the X-direction as the optical axis direction. The third linear mover 345 includes, for example, a rod 345r and a driver 345m. The rod 345r is connected to, for example, the holder 31. The driver 345m moves, for example, the rod 345r in the X-direction. The driver 345m includes, for example, a motor and a ball screw. In this example, the driver 345m moves the rod 345r in the X-direction to move the holder 31 in the X-direction. The controller 36 controls, for example, the degree of movement and the position of the holder 31 in the X-direction by controlling the rotational speed of the motor included in the driver 345m. The controller 36 may control the time to stop the motor by, for example, detecting the rotational speed of the motor in the driver 345m. The driver 345m may include, for example, an actuator selected from various actuators. Although the rod 345r has one supported end in the longitudinal direction in the example of FIGs. 22A and 22B, the rod 345r may have two supported ends in the longitudinal direction.

In a photoconversion device 30 with a second structure according to the sixth embodiment illustrated in FIGs. 23A and 23B, the drive 34 includes a fourth linear mover 346 as an example second mover for moving the wavelength converter 32 in the X-direction as the optical axis direction. The fourth linear mover 346 includes, for example, a rod 346r and a driver 346m. The rod 346r is connected to, for example, the rod 33r in the heat sink 33. The driver 346m moves, for example, the rod 346r in the X-direction. The driver 346m includes, for example, a motor and a ball screw. In this example, the driver 346m moves the rod 346r in the X-direction to move the heat sink 33 and the wavelength converter 32 in the X-direction. The controller 36 controls, for example, the degree of movement and the position of the wavelength converter 32 in the X-direction by controlling the rotational speed of the motor included in the driver 346m. The controller 36 may control the time to stop the motor by, for example, detecting the rotational speed of the motor in the driver 346m. The driver 346m may include, for example, an actuator selected from various actuators. Although the rod 346r has one supported end in the longitudinal direction in the example of FIGs. 23A and 23B, the rod 346r may have two supported ends in the longitudinal direction. For example, the photoconversion device 30 may include at least one of the third linear mover 345 or the fourth linear mover 346.

In the example of FIGs. 24A to 24C, the wavelength converter 32 includes the multiple phosphor areas 320 including the first phosphor area 320a and the second phosphor area 320b. In the example of FIGs. 24A to 24C, the wavelength converter 32 is divided into the first phosphor area 320a, the second phosphor area 320b, and the third phosphor area 320c. When, for example, at least one of the wavelength converter 32 or the holder 31 is moved in the X-direction, the size of the illuminating area I1 is changed in accordance with the distance between the first output end 2e2 and the wavelength converter 32. For example, the proportions of the multiple phosphor areas 320 in the illuminating area I1 are thus changed. This changes, for example, the wavelength spectrum of fluorescence W0 emitted by the wavelength converter 32 to adjust the colors of emission light from the photoconversion device 30.

When, for example, the wavelength converter 32 is viewed in plan in the X-direction (more specifically, in the negative X-direction) as the optical axis direction of excitation light P0 as illustrated in FIGs. 24A to 24C, or in other words, in a plan view of the wavelength converter 32 in the X-direction (more specifically, in the negative X-direction) as the optical axis direction of excitation light P0, the multiple phosphor areas 320 may be arranged in a direction away from the optical axis A2. In this case, when, for example, the distance between the first output end 2e2 and the wavelength converter 32 is changed, as illustrated in FIGs. 24A to 24C, the size of the illuminating area I1 is changed, and the proportions of the multiple phosphor areas 320 in the illuminating area I1 may be changed easily. For example, the photoconversion device 30 can thus easily adjust the colors of emission light. In the example of FIG. 24A, the illuminating area I1 includes the first phosphor area 320a alone. Thus, for example, fluorescence W0 emitted by the wavelength converter 32 is fluorescence with the first color temperature emitted from the first phosphor area 320a. When, for example, the distance between the first output end 2e2 and the wavelength converter 32 is longer, the illuminating area I1 has a greater diameter. In this case, the illuminating area I1 includes the first phosphor area 320a and the third phosphor area 320c as illustrated in FIG. 24B. In this case, for example, fluorescence W0 emitted by the wavelength converter 32 is a mixture of fluorescence with the first color temperature emitted from the first phosphor area 320a and fluorescence with the third color temperature emitted from the third phosphor area 320c. For example, the mixing ratio of the fluorescence having the first color temperature and the fluorescence having the third color temperature may be determined in accordance with, for example, the proportions of the first phosphor area 320a and the third phosphor area 320c in the illuminating area I1. When, for example, the distance between the first output end 2e2 and the wavelength converter 32 is still longer, the illuminating area I1 has a still greater diameter. In this case, the illuminating area I1 includes the first phosphor area 320a, the third phosphor area 320c, and the second phosphor area 320b as illustrated in FIG. 24C. In this case, for example, fluorescence W0 emitted by the wavelength converter 32 is a mixture of fluorescence with the first color temperature emitted from the first phosphor area 320a, fluorescence with the third color temperature emitted from the third phosphor area 320c, and fluorescence with the second color temperature emitted from the second phosphor area 320b. For example, the mixing ratio of the fluorescence having the first color temperature, the fluorescence having the third color temperature, and the fluorescence having the second color temperatures may be determined in accordance with, for example, the proportions of the first phosphor area 320a, the third phosphor area 320c, and the second phosphor area 320b in the illuminating area I1.

The wavelength converter 32 has a diameter of, for example, about 0.1 to 20 millimeters (mm). The first phosphor area 320a has a diameter of about 0.1 to 10 mm. The illuminating area I1 has a diameter of, for example, about 0.1 to 10 mm. When, for example, viewed in plan in the optical axis direction along the optical axis A2, or in other words, in a plan view in the optical axis direction along the optical axis A2, the wavelength converter 32 and the multiple phosphor areas 320 may each have a shape other than a circle, such as a rectangle. For example, the wavelength converter 32 may include two, four, or more phosphor areas 320. In other words, the wavelength converter 32 may include, for example, two or more phosphor areas 320.

When, for example, the first phosphor area 320a includes an area on the optical axis A2 in the wavelength converter 32, the photoconversion device 30 is used as appropriate for frequent use of fluorescence with the first wavelength spectrum. In this case, the first wavelength spectrum and the first color temperature of fluorescence emitted from the first phosphor area 320a in response to the excitation light P0 may be set as appropriate in accordance with the wavelength spectrum and the color temperature of frequent use.

In the photoconversion device 30 with the second structure according to the sixth embodiment, the wavelength converter 32 may include the front portion 32a located in the negative X-direction and the rear portion 32b located in the positive X-direction, and the holder 31 may hold the first output end 2e2 to apply the excitation light P0 obliquely to the front portion 32a as illustrated in FIGs. 25A and 25B. In this case, the heat sink 33 extends from the rear portion 32b of the wavelength converter 32 in the positive X-direction, and the rod 33r extends in the positive X-direction.

For example, the third linear mover 345 as an example second mover moves the holder 31 in the optical axis direction along the optical axis A2 obliquely to the imaginary line A4. More specifically, the driver 345m moves the rod 345r in the optical axis direction to move the holder 31 and the first output end 2e2 in the optical axis direction. The controller 36 controls, for example, the degrees of movement and the positions of the holder 31 and the first output end 2e2 in the optical axis direction by controlling the rotational speed of the motor in the driver 345m. For example, the fourth linear mover 346 as an example second mover moves the wavelength converter 32 in the optical axis direction along the optical axis A2 obliquely to the imaginary line A4. More specifically, the driver 346m moves, for example, the rod 346r in the optical axis direction to move the heat sink 33 and the wavelength converter 32 in the optical axis direction. The controller 36 controls, for example, the degree of movement and the position of the wavelength converter 32 in the optical axis direction by controlling the rotational speed of the motor in the driver 346m. For example, the photoconversion device 30 may include at least one of the third linear mover 345 or the fourth linear mover 346.

In the photoconversion device 30 with the second structure according to the sixth embodiment, the heat sink 33 may be, for example, a transparent member as illustrated in FIGs. 26A and 26B. In this case, for example, the wavelength converter 32 emits fluorescence W0 from both the front portion 32a and the rear portion 32b. In a photoconversion device 30 with a fourth structure according to the sixth embodiment illustrated in FIGs. 26A and 26B, the heat sink 33 includes, for example, a transparent substrate connected to the rod 33r being transparent. The heat sink 33 is, for example, a transparent member with high thermal conductivity (highly thermally conductive transparent member). For example, the highly thermally conductive transparent member may be located on the front portion 32a of the wavelength converter 32.

### 2-6. Seventh Embodiment

In each of the above embodiments, for example, the relay 3 and the second optical transmission fiber 4 may be replaced with the first optical transmission fiber 2 extending from the light-emitting module 1 to the optical radiation module 5, and the optical radiation module 5 may include a photoconversion device 30F with the same or similar structure as the photoconversion device 30 according to any of the first to sixth embodiments, as illustrated in FIG. 27.

As illustrated in FIG. 27, an illumination system 100F according to a seventh embodiment includes, for example, the light-emitting module 1, the first optical transmission fiber 2, and the optical radiation module 5. In this example, the first optical transmission fiber 2 includes the first input end 2e1 located inside the light-emitting module 1 and a first output end 2e2 of the first optical transmission fiber 2 located inside the optical radiation module 5. The first optical transmission fiber 2 can thus transmit, for example, excitation light P0 from the light-emitting module 1 to the optical radiation module 5. In the optical radiation module 5, for example, the photoconversion device 30F can receive excitation light P0 output through the first output end 2e2 of the first optical transmission fiber 2 as an output portion to emit fluorescence W0. The optical radiation module 5 can then radiate, for example, the fluorescence W0 emitted from the photoconversion device 30F into an external space 200 of the illumination system 100F as illumination light I0.

In this structure as well, the photoconversion device 30F includes, for example, the holder 31, the wavelength converter 32, the drive 34, and the controller 36. The holder 31 holds the first output end 2e2 that serves as an output portion. The wavelength converter 32 includes the multiple phosphor areas 320. The drive 34 changes the illuminating area I1 in the multiple phosphor areas 320. The controller 36 drives the drive 34 to change the illuminating area I1 in the multiple phosphor areas 320 and stops driving the drive 34 to define the illuminating area I1 in the multiple phosphor areas 320. This changes, for example, the wavelength spectrum of fluorescence W0 emitted by the wavelength converter 32 to adjust the colors of emission light from the photoconversion device 30. The structure can adjust the colors of emission light without increasing the number of light-emitting elements. For example, the photoconversion device 30 can thus easily adjust the colors of emission light. In the illumination system 100F, for example, the wavelength converter 32 in the optical radiation module 5 emits fluorescence W0 in response to the excitation light P0 transmitted by the first optical transmission fiber 2 from the light-emitting module 1. This structure reduces optical transmission loss that may occur when, for example, the fluorescence W0 travels through the optical transmission fiber in a direction inclined at various angles to the longitudinal direction of the optical transmission fiber and is partly scattered during transmission. Thus, the illumination system 100F can radiate, for example, fluorescence W0 with higher light intensity in response to the excitation light P0.

An optical radiation module 5 with a first structure according to the seventh embodiment illustrated in FIGs. 28A and 28B includes the photoconversion device 30F and an optical radiator 50. In this example, the photoconversion device 30F has the same or similar structure as the photoconversion device 30 according to the first embodiment illustrated in FIGs. 2A and 2B. The optical radiator 50 includes, for example, an optical transmitter 51 and an optical system L53. The optical transmitter 51 can transmit, for example, fluorescence W0 from the second focal point F2 toward the optical system L53. The optical transmitter 51 includes, for example, an optical fiber or a cylindrical member with a mirrorlike inner surface. The optical transmitter 51 includes, for example, one end 5e1 (also referred to as a third input end) for receiving the fluorescence W0 and another end 5e2 (also referred to as a third output end) for outputting the fluorescence W0. The third output end 5e2 is located opposite to the third input end 5e1. In the example of FIGs. 28A and 28B, the optical system L53 is aligned with, for example, the third output end 5e2 of the optical transmitter 51. The optical system L53 can radiate, for example, the fluorescence W0 transmitted by the optical transmitter 51 into the external space 200 at an intended angle of light distribution. The optical system L53 may include, for example, a lens or a diffuser. In this structure, for example, the optical radiation module 5 can include a smaller portion to radiate the fluorescence W0 into the external space 200 as illumination light I0.

An optical radiation module 5 with a first structure according to the seventh embodiment may not include the optical radiator 50 and may include the reflective surface 35r along a parabolic plane and the focal point F0 of the parabolic plane along the wavelength converter 32 as illustrated in FIGs. 29A and 29B. In this case, the photoconversion device 30F may emit, for example, collimated light of fluorescence W0 as illustrated in FIG. 29B. The collimated light may be, for example, radiated into the external space 200 as illumination light I0 directly or through various optical systems such as a lens or a diffuser.

### 2-7. Eighth Embodiment

In each of the above first to sixth embodiments, for example, the relay 3 and the first optical transmission fiber 2 may be replaced with the second optical transmission fiber 4 extending from the light-emitting module 1 to the optical radiation module 5, and the light-emitting module 1 may include a photoconversion device 30G with the same or similar structure as the photoconversion device 30 according to any of the first to sixth embodiments, as illustrated in FIG. 30.

As illustrated in FIG. 30, an illumination system 100G according to an eighth embodiment includes, for example, the light-emitting module 1, the second optical transmission fiber 4, and the optical radiation module 5. In this example, the second optical transmission fiber 4 includes the second input end 4e1 located inside the light-emitting module 1 and a second output end 4e2 located inside the optical radiation module 5. The second optical transmission fiber 4 can thus, for example, transmit fluorescence W0 from the light-emitting module 1 to the optical radiation module 5. In the light-emitting module 1, for example, the photoconversion device 30G can receive excitation light P0 emitted by the light-emitting element 10 as an output portion to emit fluorescence W0. The fluorescence W0 emitted from the photoconversion device 30G in the light-emitting module 1 is, for example, transmitted to the optical radiation module 5 through the second optical transmission fiber 4. The optical radiation module 5 can then radiate, for example, the fluorescence W0 transmitted by the second optical transmission fiber 4 into the external space 200 of the illumination system 100G as illumination light I0.

In this structure as well, the photoconversion device 30G includes, for example, the holder 31, the wavelength converter 32, the drive 34, and the controller 36. The holder 31 holds the light-emitting element 10 that serves as an output portion. The wavelength converter 32 includes the multiple phosphor areas 320. The drive 34 changes the illuminating area I1 in the multiple phosphor areas 320. The controller 36 drives the drive 34 to change the illuminating area I1 in the multiple phosphor areas 320 and stops driving the drive 34 to define the illuminating area I1 in the multiple phosphor areas 320. This changes, for example, the wavelength spectrum of fluorescence W0 emitted by the wavelength converter 32 to adjust the colors of emission light from the photoconversion device 30. The structure can adjust the colors of emission light without increasing the number of light-emitting elements. For example, the photoconversion device 30 can thus easily adjust the colors of emission light. In the illumination system 100G, for example, the optical radiation module 5 may not include the wavelength converter 32. The optical radiation module 5 is thus, for example, less likely to undergo temperature increase and can be miniaturized.

A light-emitting module 1 with an example structure according to the eighth embodiment illustrated in FIGs. 31A and 31B includes the light-emitting element 10 and the photoconversion device 30G. In this example, the photoconversion device 30G has the same or similar structure as the photoconversion device 30 according to the first embodiment illustrated in FIGs. 2A and 2B. In the example of FIGs. 31A and 31B, excitation light P0 is emitted from an output portion 10f of the light-emitting element 10 toward the wavelength converter 32, instead of through the first output end 2e2 of the first optical transmission fiber 2. The holder 31 holds the light-emitting element 10. The holder 31 may have, for example, a shape selected from various shapes and may hold the light-emitting element 10 in a manner selected from various manners.

### 3. Others

In each of the above embodiments, for example, the fluorescence with the first wavelength spectrum, the fluorescence with the second wavelength spectrum, and the fluorescence with the third wavelength spectrum may each be fluorescence with a specific color. The fluorescence with a specific color may be, for example, red (R) fluorescence, green (G) fluorescence, or blue (B) fluorescence. In this case, for example, the fluorescence with the first wavelength spectrum may be red (R) fluorescence, the fluorescence with the second wavelength spectrum may be green (G) fluorescence, and the fluorescence with the third wavelength spectrum may be blue (B) fluorescence. In this case, for example, the first phosphor area 320a may contain a red phosphor, the second phosphor area 320b may contain a green phosphor, and the third phosphor area 320c may contain a blue phosphor.

In each of the above embodiments, for example, the front portion 32a and the rear portion 32b may each be a planar portion, such as a circular or polygonal portion, or a non-flat portion, such as a curved portion or an uneven portion. For example, the wavelength converter 32 may be in the shape of a cone including the planar rear portion 32b and the front portion 32a having a vertex or may be in the shape of a hemisphere including the planar rear portion 32b and the hemispherical front portion 32a. The shape of the cone may be, for example, a polygonal pyramid, such as a triangular pyramid or a quadrangular pyramid, or a circular cone.

In each of the above embodiments, for example, the wavelength converter 32 may include multiple phosphor areas 320 that are integral with one another, or may include two or more portions formed separately and then multiple phosphor areas 320 are arranged in the multiple portions as appropriate.

The photoconversion device 30 according to each of the above third and fourth embodiments, the photoconversion devices 30 with the third and fourth structures according to the above fifth embodiment, and the photoconversion devices 30 with the third and fourth structures according to the sixth embodiment may not include, for example, the reflector 35.

In each of the above embodiments, for example, the color temperature or the color of the fluorescence W0 emitted from each of the photoconversion devices 30, 30F, and 30G may be detected by a sensor, and the controller 36 may control the driving of the drive 34 based on the detection result.

In each of the above embodiments, for example, the reflective surface 35r may be a concave surface displaced from the imaginary ellipsoid 35e, and may reflect fluorescence W0 focused using an optical system. For example, the reflective surface 35r may extend along a paraboloid, and collimated light of the fluorescence W0 reflected from the reflective surface 35r may be focused through a condenser lens.

In each of the above embodiments, for example, any of the X-direction, Y-direction, and Z-direction may be the vertical direction, or any other direction may be the vertical direction.

In the above fifth embodiment, for example, the drive 34 may include the rods 343r and 344r both elongated in the Y-direction and to be swung with the drivers 343m and 344m. In this structure as well, the drive 34 moves, for example, the wavelength converter 32 and the holder 31 relative to each other in the direction intersecting with the optical axis A2 of the excitation light P0.

In each of the above embodiments, for example, the drive 34 may include, between the output portion and the wavelength converter 32, an optical system that is moved to change the illuminating area I1 receiving the excitation light P0 in the multiple phosphor areas 320. The optical system may include various components including a lens, a prism, and a reflector. The optical system may be moved by translating, rotating, and swinging various components. The illuminating area I1 being changed includes, for example, the illuminating area I1 being moved by redirecting the optical axis A2 of the excitation light P0, and the illuminating area I1 with the diameter being increased or decreased by increasing or decreasing the beam diameter of the excitation light P0.

In the photoconversion device 30 according to the above first embodiment, the photoconversion device 30 with the first structure according to the above fourth embodiment, the photoconversion device 30 with the first structure according to the above fifth embodiment, and the optical radiation modules 5 with the first and second structures according to the above seventh embodiment, for example, the holder 31 may not be included in the photoconversion device 30 or 30F and may be located outside the photoconversion device 30 or 30F. In the light-emitting module 1 with the example structure according to the above eighth embodiment, for example, the holder 31 may not be included in the photoconversion device 30G and may be located outside the photoconversion device 30G.

In the photoconversion device 30 according to the above first embodiment, the photoconversion device 30 with the first structure according to the above fourth embodiment, the photoconversion device 30 with the first structure according to the above fifth embodiment, and the optical radiation modules 5 with the first and second structures according to the above seventh embodiment, for example, the holder 31 may not be included, and the reflector 35 may hold the first output end 2e2 that serves as an output portion in the through-hole 35h or with another component. In the light-emitting module 1 with the example structure according to the above eighth embodiment, for example, the holder 31 may not be included, and the reflector 35 may hold the output portion 10f in the through-hole 35h or with another component.

The components described in the above embodiments and variations may be entirely or partially combined as appropriate unless any contradiction arises.

### REFERENCE SIGNS

1 light-emitting module
10 light-emitting element
100, 100F, 100G illumination system
10f output portion
2 first optical transmission fiber
200 external space
2e1 first input end
2e2 first output end
3 relay
30, 30F, 30Gphotoconversion device
31 holder
32 wavelength converter
320 phosphor area
320a first phosphor area
320b second phosphor area
320c third phosphor area
320d fourth phosphor area
320e fifth phosphor area
34 drive
341 first rotator
342 second rotator
343 first linear mover
344 second linear mover
345 third linear mover
346 fourth linear mover
35 reflector
35e imaginary ellipsoid
35r reflective surface
36 controller
4 second optical transmission fiber
4e1 second input end
4e2 second output end
5 optical radiation module
A2 optical axis
B1, B2 boundary
F1 first focal point
F2 second focal point
I0 illumination light
I1 illuminating area
P0 excitation light
R1 first rotation axis
R2 second rotation axis
W0 fluorescence

## Claims

1. A photoconversion device, comprising:
a wavelength converter including a plurality of phosphor areas including a first phosphor area to emit fluorescence with a first wavelength spectrum in response to excitation light and a second phosphor area to emit fluorescence with a second wavelength spectrum different from the first wavelength spectrum in response to the excitation light;
a drive configured to change an illuminating area to receive the excitation light in the plurality of phosphor areas; and
a controller configured to drive the drive to change the illuminating area in the plurality of phosphor areas and stop driving the drive to define the illuminating area in the plurality of phosphor areas.

2. The photoconversion device according to claim 1, further comprising:
a holder holding an output portion configured to output the excitation light.

3. The photoconversion device according to claim 2, wherein
the drive moves a part of at least one of the holder or the wavelength converter to change a relative positional relationship between the output portion and the plurality of phosphor areas.

4. The photoconversion device according to claim 3, wherein
the drive includes a first rotator configured to rotate the wavelength converter about an imaginary first rotation axis different from an optical axis of the excitation light applicable to the wavelength converter.

5. The photoconversion device according to claim 4, wherein
the plurality of phosphor areas is arranged circumferentially about the first rotation axis in a plan view of the wavelength converter in a direction along the first rotation axis.

6. The photoconversion device according to claim 4 or claim 5, wherein
the first phosphor area includes an area on the first rotation axis in the wavelength converter and overlaps the illuminating area in the wavelength converter.

7. The photoconversion device according to claim 3, wherein
the drive includes a second rotator configured to rotate the holder about an imaginary second rotation axis different from an optical axis of the excitation light.

8. The photoconversion device according to claim 7, wherein
the plurality of phosphor areas is arranged circumferentially about the second rotation axis in a plan view of the wavelength converter in a direction along the second rotation axis.

9. The photoconversion device according to claim 7 or claim 8, wherein
the first phosphor area includes an area on the second rotation axis in the wavelength converter and overlaps the illuminating area in the wavelength converter.

10. The photoconversion device according to any one of claims 3 to 9, wherein
the drive includes a first mover configured to move the wavelength converter and the holder relative to each other in an intersection direction intersecting with an optical axis of the excitation light.

11. The photoconversion device according to claim 10, wherein
the plurality of phosphor areas is arranged in the intersection direction in a plan view of the wavelength converter in a direction along the optical axis of the excitation light.

12. The photoconversion device according to claim 11, wherein
a boundary between the first phosphor area and the second phosphor area extends obliquely to the intersection direction in a plan view of the wavelength converter in the direction along the optical axis of the excitation light.

13. The photoconversion device according to any one of claims 2 to 11, wherein
the drive includes a second mover configured to change a distance between the holder and the wavelength converter in an optical axis direction along an optical axis of the excitation light.

14. The photoconversion device according to claim 13, wherein
the plurality of phosphor areas is arranged in a direction away from the optical axis of the excitation light in a plan view of the wavelength converter in the optical axis direction.

15. The photoconversion device according to claim 14, wherein
the first phosphor area includes an area on the optical axis of the excitation light in the wavelength converter.

16. The photoconversion device according to any one of claims 1 to 15, wherein
the fluorescence with the first wavelength spectrum and the fluorescence with the second wavelength spectrum have different color temperatures.

17. The photoconversion device according to any one of claims 1 to 16, further comprising:
a reflector surrounding the wavelength converter and configured to reflect the fluorescence emitted by the wavelength converter.

18. The photoconversion device according to claim 17, wherein
the reflector includes an ellipsoidal mirror with a reflective surface along an ellipsoid, and
the ellipsoid includes a first focal point along the first wavelength converter.

19. The photoconversion device according to any one of claims 2 to 18, wherein
the output portion includes an output end of an optical transmission fiber.

20. The photoconversion device according to claim 18, wherein
the ellipsoid includes a second focal point different from the first focal point, and the second focal point is aligned with an input end of an optical transmission fiber.

21. An illumination system, comprising:
a light-emitting module configured to emit excitation light;
a first optical transmission fiber configured to transmit the excitation light from the light-emitting module;
a relay including the photoconversion device according to claim 1;
a second optical transmission fiber configured to transmit the fluorescence from the relay; and
an optical radiation module configured to radiate the fluorescence transmitted by the second optical transmission fiber into an external space.

22. An illumination system, comprising:
a light-emitting module configured to emit excitation light;
a first optical transmission fiber configured to transmit the excitation light from the light-emitting module;
a relay including the photoconversion device according to any one of claims 2 to 20;
a second optical transmission fiber configured to transmit the fluorescence from the relay; and
an optical radiation module configured to radiate the fluorescence transmitted by the second optical transmission fiber into an external space,
wherein the output portion includes an output end of the first optical transmission fiber.
